(19) Europäisches Patentamt
European Patent Office
Office européen des brevets

(11) **EP 3 785 367 B1**

(12) **FASCICULE DE BREVET EUROPEEN**

(45) Date de publication et mention de la délivrance du brevet:
**23.02.2022 Bulletin 2022/08**

(21) Numéro de dépôt: **19724936.0**

(22) Date de dépôt: **23.04.2019**

(51) Classification Internationale des Brevets (IPC):
**H03F 3/24** *(2006.01)*     **H03F 3/189** *(2006.01)*
**H03F 1/02** *(2006.01)*     **H03F 1/32** *(2006.01)*

(52) Classification Coopérative des Brevets (CPC):
**H03F 3/24; H03F 1/025; H03F 1/3247;**
**H03F 1/3258; H03F 1/3294; H03F 3/189;**
H03F 2200/451

(86) Numéro de dépôt international:
**PCT/IB2019/053335**

(87) Numéro de publication internationale:
**WO 2019/207476 (31.10.2019 Gazette 2019/44)**

(54) **SYSTEME ET PROCEDE DE LINEARISATION EN BANDE DE BASE POUR UN AMPLIFICATEUR DE PUISSANCE RADIOFREQUENCE DE CLASSE G**

SYSTEM UND VERFAHREN ZUR BASISBANDLINEARISIERUNG FÜR EINEN HOCHFREQUENZLEISTUNGSVERSTÄRKER DER KLASSE G

SYSTEM AND METHOD OF BASEBAND LINEARISATION FOR A CLASS G RADIOFREQUENCY POWER AMPLIFIER

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.04.2018 FR 1853628**

(43) Date de publication de la demande:
**03.03.2021 Bulletin 2021/09**

(73) Titulaire: **Wupatec**
**87000 Limoges (FR)**

(72) Inventeurs:
• **GATARD, Emmanuel**
**87350 Panazol (FR)**
• **LACHAUD, Pierre**
**87590 Saint Just le Martel (FR)**

(74) Mandataire: **Cabinet Chaillot**
**16/20, avenue de l'Agent Sarre**
**B.P. 74**
**92703 Colombes Cedex (FR)**

(56) Documents cités:
**US-A1- 2001 001 546     US-A1- 2010 073 088**
**US-A1- 2010 277 236     US-A1- 2014 118 065**

**Description**

La présente invention concerne le domaine des systèmes de télécommunication sans fil, et porte en particulier sur un système et un procédé de linéarisation en bande de base pour un amplificateur de puissance radiofréquence de classe G.

Au sein des systèmes de télécommunication sans fil, l'amplificateur de puissance apparaît comme un élément critique pour le développement de nouvelles applications telles que celles envisagées pour la cinquième génération (5G) ou bien encore pour l'Internet des objets (IdO).

Les amplificateurs de puissance doivent aujourd'hui être capables de s'auto-adapter aux types de signaux à émettre afin d'optimiser leur consommation énergétique mais également d'assurer des exigences fortes en linéarité vis-à-vis de modulations de plus en plus complexes.

Les nouveaux standards de communication sans fil nécessitent l'emploi de modulations complexes à haute efficacité spectrale, telles que l'OFDM (multiplexage par répartition orthogonale de la fréquence), dans l'objectif d'optimiser les capacités des liaisons déployées. Ces modulations présentent des facteurs de crête importants (c'est-à-dire des rapports importants entre la puissance crête et la puissance moyenne du signal) et de larges bandes passantes de modulation.

Dans ce contexte, les amplificateurs de puissance radiofréquence (RF) ou hyperfréquence (HF) conventionnels qui sont alimentés par une tension d'alimentation continue fournissent un rendement relativement faible, l'amplificateur de puissance fonctionnant la plupart du temps dans des conditions où son rendement est bien inférieur à son rendement maximal.

La technique de suivi d'enveloppe est une technique d'alimentation permettant d'améliorer le rendement des amplificateurs de puissance radiofréquence. Elle remplace l'alimentation continue de l'amplificateur de puissance par une alimentation dynamique dont le niveau dépend de la puissance à émettre. Cette technique présente de nombreux atouts par rapport à d'autres techniques d'optimisation de rendement utilisées notamment dans les stations de base pour la téléphonie mobile.

La technique de suivi d'enveloppe permet d'ajuster dynamiquement la tension d'alimentation de l'amplificateur de puissance radiofréquence afin que celui-ci fonctionne toujours à son rendement maximal quel que soit le niveau de puissance du signal à émettre.

Dans le cas d'un amplificateur de puissance utilisant la technique de suivi d'enveloppe, la tension d'alimentation est, par définition, constamment réajustée afin de s'assurer que l'amplificateur de puissance fonctionne toujours à la compression et donc à son rendement maximal quel que soit le niveau de puissance souhaité à l'émission.

Une technique particulière liée à la technique de suivi d'enveloppe s'appuie sur l'utilisation d'un signal d'alimentation de l'amplificateur de puissance de type multi-niveaux (ou à multiples niveaux discrets d'alimentation). Le fonctionnement de l'amplificateur de puissance radiofréquence est alors celui d'un amplificateur de puissance fonctionnant en classe G.

L'amplification en classe G est simple à mettre en œuvre mais ne permet pas d'améliorer le rendement de l'amplificateur de puissance autant que pour la technique de suivi d'enveloppe continue.

La génération d'un signal de commande d'alimentation à multiples niveaux discrets est assurée par la sélection d'une tension d'alimentation parmi une pluralité d'alimentations disposées en parallèle ou en série. Cette technique d'amplification particulière présente l'avantage de supporter de très larges bandes passantes de modulation tout en maintenant un rendement élevé du modulateur d'alimentation fournissant la tension d'alimentation à l'amplificateur de puissance.

Pour un signal d'alimentation exploitant plusieurs niveaux discrets d'alimentation, chaque tension d'alimentation appliquée est définie pour une plage de puissance d'entrée de l'amplificateur de puissance. L'étendue de chaque plage dépend principalement du nombre de niveaux discrets disponibles et des caractéristiques de l'amplificateur de puissance. Les tensions d'alimentation ne sont pas obligatoirement équiréparties entre la tension minimale et la tension maximale fournies à l'amplificateur de puissance radiofréquence.

En radiofréquences ou hyperfréquences, les variations importantes des caractéristiques électriques de l'amplificateur de puissance en fonction de la puissance, de la fréquence ou bien encore de la tension d'alimentation conduisent à des distorsions du signal à émettre. Les amplificateurs de puissance nécessitent souvent l'utilisation d'une fonction de linéarisation adaptée à leur mode de fonctionnement.

L'amplification de puissance radiofréquence en classe G, c'est-à-dire utilisant une tension d'alimentation composée de multiples niveaux discrets, permet de grandement améliorer le rendement des systèmes même pour de très larges bandes passantes de modulation. Cependant, cette technique nécessite d'être couplée à une technique de linéarisation afin de supprimer les importantes distorsions introduites par ce type de technique d'amplification. Des méthodes de pré-distorsion sont largement répandues pour les applications d'amplification de puissance pour les télécommunications. Toutefois, elles ne sont pas utilisables pour une amplification de puissance de type classe G.

Les amplificateurs de puissance radiofréquence en fonctionnement classe G peuvent présenter des variations importantes du gain en puissance et du déphasage de l'amplificateur entre les différentes tensions d'alimentation.

Les variations de gain et de phase de l'amplificateur de puissance sont fonction de la fréquence, de la puissance fournie mais aussi de la tension d'alimentation. Elles conduisent alors à des distorsions importantes du signal à émettre.

Ces distorsions prennent place dans la bande passante du signal à émettre et se traduisent alors par des erreurs de transmission, mais prennent également place dans les canaux adjacents du signal à émettre et se traduisent dans ce cas par le brouillage de ces canaux de communication.

US 2010/277236 A1 divulgue un système de linéarisation en bande de base pour un amplificateur de puissance radiofréquence compensant des éléments de dégradation de la qualité du signal de sortie tels que la distorsion non linéaire, la distorsion linéaire et les effets de mémoire.

La présente invention vise à résoudre les inconvénients de l'état antérieur de la technique, en proposant un système de linéarisation en bande de base pour un amplificateur de puissance radiofréquence de classe G, ledit système de linéarisation comprenant un filtre numérique à coefficients complexes disposé à la sortie du module de pré-distorsion numérique, ce qui permet de supprimer les distorsions induites par le mode de fonctionnement en classe G de l'amplificateur de puissance radiofréquence, ces distorsions prenant naissance notamment en raison des différences de gain et de phase pour chacune des tensions d'alimentation de l'amplificateur de puissance radiofréquence de classe G mais également en raison du temps requis pour la commutation d'une tension d'alimentation discrète à une autre.

La présente invention a donc pour objet un système de linéarisation en bande de base pour un amplificateur de puissance radiofréquence (RF) de classe G, en accord avec la revendication indépendante 1 ainsi qu'un procédé d'extraction des coefficients du filtre numérique à coefficients complexes d'un système de linéarisation en bande de base pour un amplificateur de puissance radiofréquence, RF, de classe G selon la revendication 11. Les modes de réalisation préférentiels sont l'objet des revendications dépendantes 2 à 10.

Le nombre maximal de tensions d'alimentation continues est, de préférence, égal à 16.

Ainsi, le filtre numérique à coefficients complexes permet d'annuler les distorsions générées dans la bande du signal modulé et dans les canaux adjacents. Il permet par ailleurs d'annuler le bruit spectral généré par les distorsions lors de chaque changement de niveau d'alimentation de l'amplificateur de puissance RF de classe G. L'annulation du bruit spectral est réalisée sur toute la bande passante instantanée de génération du signal RF. L'invention permet d'atteindre des niveaux de bruit dans les canaux adjacents identiques à ceux obtenus sur un amplificateur de puissance RF fonctionnant typiquement en classe AB.

Le système de linéarisation est réalisé en bande de base au sein d'un circuit numérique sur les composantes en phase et en quadrature (I et Q) du signal modulé à émettre. La modification du signal à émettre s'effectue en cascadant le module de pré-distorsion numérique et le filtre numérique réalisés en bande de base, chacun du module de pré-distorsion numérique et du filtre numérique étant couplé à un module d'extraction de coefficients dédié à l'amplification de classe G.

Ainsi, le système de linéarisation selon l'invention associé à un amplificateur de puissance RF de classe G permet de fournir un gain en puissance et un déphasage constants à chaque instant de fonctionnement.

Le module de pré-distorsion numérique utilisé pour la linéarisation s'appuie sur une pré-distorsion numérique en bande de base qui est une fonction non linéaire correspondant à la fonction de transfert inverse de l'amplificateur de puissance à linéariser. La mise en œuvre du module de pré-distorsion numérique nécessite des ressources numériques limitées et permet d'atteindre une très nette amélioration des performances en linéarité de l'amplificateur de puissance.

Lorsqu'un amplificateur de puissance RF de classe G est couplé à un module de pré-distorsion numérique, des distorsions résiduelles apparaissent en sortie du système global au moment de chaque changement de niveau d'alimentation.

Les vitesses de commutation entre les niveaux d'alimentation étant du même ordre de grandeur que les débits symboles des modulations à émettre notamment pour de larges bandes passantes, des distorsions apparaissent en sortie du système global au moment de chaque changement de niveau d'alimentation. Lors de ces transitions, la sortie du module de pré-distorsion numérique n'est alors plus en adéquation avec la tension d'alimentation réellement appliquée à l'amplificateur de puissance.

Les distorsions introduites par chaque changement de niveau d'alimentation ont pour effet de générer un bruit spectral de part et d'autre de la bande passante du signal utile. Ces distorsions résiduelles se traduisent par l'introduction de composantes spectrales indésirables dans les canaux de communication adjacents. Cependant, l'occupation spectrale de ce type de distorsions est finie et directement liée à la vitesse de commutation entre les différents niveaux d'alimentations et à la bande passante instantanée de génération du signal modulé en radiofréquence.

Dans la présente invention, la suppression des distorsions résiduelles en sortie de l'amplificateur de puissance RF de classe G couplé au module de pré-distorsion numérique est opérée à l'aide du filtre numérique spécifique réalisé en bande de base. L'utilisation d'un tel filtre est essentielle afin de prendre en compte les caractéristiques fréquentielles de l'amplificateur de puissance. Un amplificateur de puissance RF présente en effet des caractéristiques de gain et de phase qui sont dépendantes de la puissance, de la fréquence et de la tension d'alimentation. Par ailleurs, ces caractéristiques ne sont pas identiques de part et d'autre d'une fréquence porteuse d'un signal à émettre. L'annulation de ces distorsions ne peut avoir lieu que sur une bande passante radiofréquence équivalente à la largeur de bande instantanée de génération de l'émetteur.

La réponse fréquentielle du filtre numérique à coefficients complexes est, de préférence, dissymétrique entre les fréquences positives et négatives.

Ainsi, en sortie du module de pré-distorsion numérique, l'insertion dans la chaîne de traitement des données en phase et en quadrature (I et Q) en bande de base d'un filtre numérique spécifique a pour rôle de distordre le spectre du signal de linéarisation issu du module de pré-distorsion numérique afin d'annuler les distorsions spectrales résiduelles, le filtre numérique spécifique étant un filtre numérique à coefficients complexes, c'est-à-dire dont les coefficients présentent à la fois une partie réelle et une partie imaginaire.

Selon une première variante de l'invention, le module de pré-distorsion numérique est configuré pour réaliser une pré-distorsion numérique à une dimension en fonction de l'amplitude des composantes I et Q du signal à émettre.

Ainsi, une fonction de linéarisation à une dimension dépendant uniquement de l'amplitude de l'enveloppe du signal à émettre est satisfaisante pour un amplificateur de puissance de classe G du fait que la tension d'alimentation appliquée à l'amplificateur de puissance est directement liée à l'amplitude de l'enveloppe du signal à émettre.

Dans le cas d'un module de pré-distorsion numérique à une dimension, le facteur de pré-distorsion à appliquer est ainsi uniquement dépendant du module du signal complexe numérique (I et Q) en bande de base.

Selon une seconde variante de l'invention, le module de pré-distorsion numérique est configuré pour réaliser une pré-distorsion numérique à deux dimensions en fonction de l'amplitude des composantes I et Q du signal à émettre et de la tension d'alimentation sélectionnée par le module de sélection de tension d'alimentation d'amplificateur.

Ainsi, dans ce cas, on considère que les paramètres de la fonction de pré-distorsion doivent dépendre à la fois de l'amplitude de l'enveloppe du signal à émettre et de la tension d'alimentation appliquée à l'amplificateur de puissance pour des problématiques de traitement de signal.

Dans le cas d'un module de pré-distorsion numérique à deux dimensions, le facteur de pré-distorsion à appliquer est à la fois dépendant du module du signal complexe numérique (I et Q) en bande de base mais également de la tension d'alimentation qui est sélectionnée et appliquée à l'amplificateur de puissance RF de classe G.

Selon une caractéristique particulière de l'invention, le module de pré-distorsion numérique est configuré pour réaliser une pré-distorsion numérique de type polynomiale sans mémoire à l'aide d'au moins une table de correspondance stockée dans une mémoire ou d'une équation non-linéaire, ou pour réaliser une pré-distorsion numérique de type polynomiale à mémoire ou série de Volterra.

Ainsi, la fonction de pré-distorsion peut être réalisée dans un circuit numérique programmable à partir d'une table de correspondance (LUT) ou bien d'une équation mathématique.

Les données en phase I et en quadrature Q du signal à émettre sont injectées dans un module de pré-distorsion numérique s'appuyant sur une équation mathématique non-linéaire ou bien en entrée d'une table de correspondance mettant en œuvre une fonction mathématique non-linéaire.

Dans le cas d'une réalisation du module de pré-distorsion numérique à une dimension par une table de correspondance, les coefficients de pré-distorsion sont stockés dans une mémoire et indexés en fonction de l'amplitude de l'enveloppe du signal à émettre.

Dans le cas d'une réalisation du module de pré-distorsion numérique à deux dimensions par une table de correspondance, chaque zone mémoire correspond à une tension d'alimentation de l'amplificateur de puissance fonctionnant en classe G.

Le module de pré-distorsion numérique peut également s'appuyer sur une pré-distorsion numérique en bande de base à partir de fonctions mathématiques non-linéaires par exemple de type polynomiale à mémoire ou série de Volterra.

Selon une caractéristique particulière de l'invention, le système de linéarisation comprend en outre un module d'alignement disposé au niveau de la seconde entrée du système de linéarisation, ledit module d'alignement étant configuré pour aligner en amplitude et en phase le signal numérique en bande de base provenant de la sortie de l'amplificateur de puissance RF de classe G avec les autres signaux numériques en bande de base.

Ainsi, le signal provenant de la sortie de l'amplificateur de puissance est aligné d'un point de vue amplitude, retard et phase afin de correspondre aux différents signaux numériques en bande de base du système de linéarisation.

Selon l'invention, le module d'extraction de coefficients de pré-distorsion est configuré pour extraire les coefficients de pré-distorsion en fonction du signal numérique en bande de base provenant de la sortie de l'amplificateur de puissance RF de classe G, de l'une parmi la sortie du filtre numérique à coefficients complexes et la sortie du module de pré-distorsion numérique, et de la tension d'alimentation sélectionnée par le module de sélection de tension d'alimentation d'amplificateur.

L'extraction des coefficients du module de pré-distorsion numérique est réalisée à partir de la mesure du signal en sortie de l'amplificateur de puissance RF indépendamment de la présence ou non d'un filtre numérique complexe. Lorsqu'un filtre numérique complexe est présent, le module d'extraction de coefficients de pré-distorsion utilise de préférence le signal issu du module de pré-distorsion numérique mais pourrait alternativement utiliser le signal issu du filtre numérique complexe. Pour chaque tension d'alimentation appliquée, des paramètres de pré-distorsion sont extraits de manière indépendante. Les paramètres extraits sont affinés au fil des extractions successives.

Selon une caractéristique particulière de l'invention, le module d'extraction de coefficients de pré-distorsion comprend des première et seconde unités de retard temporel, une unité de séparation de données et une unité d'extraction de coefficients de pré-distorsion, la première unité de retard temporel étant configurée pour compenser le temps de propagation et de traitement du signal issu de l'un parmi le filtre numérique à coefficients complexes et le module de pré-distorsion numérique, la seconde unité de retard temporel étant configurée pour compenser le temps de propagation et de traitement du signal issu de la sortie du module de sélection de tension d'alimentation d'amplificateur, l'unité de séparation de données étant configurée pour séparer et stocker dans une mémoire les données concernant le signal numérique en bande de base provenant de la sortie de l'amplificateur de puissance et le signal retardé issu de l'un parmi le filtre numérique à coefficients complexes et le module de pré-distorsion numérique en fonction du signal retardé de sélection de tension d'alimentation, et l'unité d'extraction de coefficients de pré-distorsion étant configurée pour extraire, pour chaque tension d'alimentation, les coefficients de pré-distorsion associés à partir des données stockées en mémoire par l'unité de séparation de données.

La méthode d'extraction mise en œuvre par le module d'extraction de coefficients de pré-distorsion est identique pour l'extraction de coefficients de pré-distorsion à une dimension ou deux dimensions.

Les signaux numériques provenant de la sortie du module de pré-distorsion numérique ou bien de la sortie du filtre numérique complexe et celui mesuré en sortie de l'amplificateur de puissance RF sont préalablement alignés en amplitude, en phase et les temps de propagation sont compensés afin d'extraire les coefficients de linéarisation à appliquer à l'amplificateur de puissance.

L'unité de séparation de données est configurée pour séparer et stocker en mémoire les données entrantes dans le module d'extraction de coefficients de pré-distorsion suivant la tension d'alimentation sélectionnée. Dans le cas d'une amplification de classe G, le nombre de tensions d'alimentation possibles étant très faible, cette tâche est sans complexité et nécessite peu de ressources numériques.

L'unité d'extraction de coefficients de pré-distorsion est configurée pour extraire, de manière indépendante pour chaque tension d'alimentation possible, les coefficients du module de pré-distorsion numérique. Les coefficients extraits, pour chaque tension d'alimentation discrète, sont ensuite chargés différemment dans le module de pré-distorsion numérique suivant qu'il s'agit d'une pré-distorsion numérique à une ou deux dimensions. Par exemple, dans le cas d'un module de pré-distorsion numérique mis en œuvre à l'aide de tables de correspondance, les coefficients sont stockés dans une seule zone mémoire si le module de pré-distorsion numérique est à une dimension ou bien dans autant de zones mémoires que de tensions d'alimentation utilisées si le module de pré-distorsion numérique est à deux dimensions.

Le processus d'extraction des coefficients de pré-distorsion s'effectue à intervalles de temps prédéterminés afin d'affiner au cours du temps les coefficients de pré-distorsion et ainsi d'obtenir des performances accrues en linéarité de l'amplificateur de puissance fonctionnant en classe G. Le processus d'extraction continu des coefficients de pré-distorsion permet également de tenir compte des variations des conditions de fonctionnement de l'amplificateur de puissance telles qu'une désadaptation d'antenne ou des variations de température.

Selon l'invention, le module d'extraction de coefficients de filtre est configuré pour extraire les coefficients de filtre en fonction des composantes I et Q du signal à émettre, du signal numérique en bande de base provenant de la sortie de l'amplificateur de puissance RF de classe G, de la sortie du filtre numérique à coefficients complexes, et de la sortie du module de pré-distorsion numérique.

L'extraction des coefficients de filtre est opérée à partir de la mesure du signal de sortie de l'amplificateur de puissance lorsque le module de pré-distorsion numérique est préalablement appliqué. L'extraction des coefficients de filtre s'effectue de manière directe. Cependant, l'optimisation de ces coefficients de filtre s'effectue de manière itérative, c'est-à-dire que les valeurs des coefficients de filtre sont affinées au fil des déterminations successives.

Selon l'invention, le module d'extraction de coefficients de filtre comprend trois unités de retard temporel, une unité de calcul de gain, une unité de calcul de signal attendu de sortie de filtre, deux unités de transformée de Fourrier rapide, FFT, une unité de calcul de réponse fréquentielle de filtre et une unité d'extraction de coefficients de filtre, les trois unités de retard temporel étant respectivement configurées pour compenser les temps de propagation et de traitement des composantes I et Q du signal à émettre, de la sortie du filtre numérique à coefficients complexes et de la sortie du module de pré-distorsion numérique, l'unité de calcul de gain étant configurée pour calculer le gain complexe de l'amplificateur de puissance à partir de la sortie retardée du filtre numérique à coefficients complexes et du signal numérique en bande de base provenant de la sortie de l'amplificateur de puissance, l'unité de calcul de signal attendu de sortie de filtre étant configurée pour calculer le signal à générer par le filtre numérique à partir du gain complexe calculé et des composantes I et Q retardées du signal à émettre, les deux unités FFT étant respectivement configurées pour calculer les transformées de Fourrier de la sortie retardée du module de pré-distorsion numérique et du signal à générer par le filtre numérique calculé par l'unité de calcul de signal attendu de sortie de filtre, l'unité de calcul de réponse fréquentielle de filtre étant configurée pour calculer la réponse fréquentielle du filtre numérique à générer à partir des deux transformées de Fourrier calculées par les unités FFT, et l'unité d'extraction de coefficients de filtre étant configurée pour extraire les coefficients complexes du filtre numérique à synthétiser en fonction de la réponse fréquentielle calculée par l'unité de calcul de réponse fréquentielle de filtre.

Les différents signaux numériques utiles présents en bande de base sont préalablement alignés en amplitude, en phase et les temps de propagation sont compensés si nécessaire afin de déterminer la fonction de transfert du filtre numérique à synthétiser et à implémenter en sortie du module de pré-distorsion numérique.

Le module de pré-distorsion numérique doit obligatoirement avoir préalablement été appliqué afin de procéder à l'extraction des coefficients du filtre numérique complexe.

Initialement, au démarrage du processus d'identification, aucun filtrage n'est appliqué en sortie du module de pré-distorsion numérique. Si aucun filtrage n'est appliqué, le filtre numérique complexe prend alors un gain unitaire au démarrage du processus d'identification.

L'unité de calcul de gain permet de calculer le gain complexe du système radiofréquence à chaque instant d'échantillonnage selon l'équation :

$$Gain\ (n) = \frac{Amplifier\ OUT\ (n),}{FLT\ OUT\ (n)}$$

où $n$ est l'indice de l'échantillon, *Amplifier OUT* est le signal de sortie de l'amplificateur de puissance RF et *FLT OUT* est le signal de sortie du filtre numérique à coefficients complexes.

Dans l'unité de calcul de sortie de filtre, le nouveau signal de linéarisation à générer est calculé pour chaque instant d'échantillonnage afin d'annuler les distorsions spectrales résiduelles selon l'équation :

$$New\ FLT\ OUT\ (n) = \frac{Original\ Waveform\ (n),}{Gain\ (n)}$$

où $n$ est l'indice de l'échantillon, *Original Waveform* est le signal d'origine à émettre et *New FLT OUT* est la nouvelle sortie du filtre numérique à coefficients complexes à générer.

Dans les unités FFT, les transformées de Fourier du nouveau signal de linéarisation à générer calculé précédemment et du signal issu du module de pré-distorsion numérique sont calculées sur un nombre d'échantillons prédéfinis selon les équations :

$$New\ FLT\ OUT_{spectrum}(f) = TFD[New\ FLT\ OUT\ (n)]$$

,

$$DPD\ OUT_{spectrum}(f) = TFD[DPD\ OUT\ (n)],$$

où *TFD* désigne la fonction de transformée de Fourier discrète d'un signal échantillonné, cette fonction étant mise en œuvre à l'aide d'un algorithme de transformée de Fourier rapide (FFT), $f$ désigne l'indice de l'échantillon après transformée de Fourier, *DPD OUT est* la sortie du module de pré-distorsion numérique, *New FLT OUT $_{spectrum}$* est la transformée de Fourier de la nouvelle sortie de filtre à générer *et DPD OUT $_{spectrum}$* est la transformée de Fourier de la sortie du module de pré-distorsion numérique.

La réponse fréquentielle H du filtre numérique à générer est ensuite estimée dans l'unité de calcul de réponse fréquentielle de filtre selon l'équation :

$$H(f) = \frac{New\ FLT\ OUT_{spectrum}\ (f),}{DPD\ OUT_{spectrum}(f)}$$

où f est l'indice de l'échantillon après transformée de Fourier, cet indice correspondant à un indice de fréquence.

L'unité d'extraction de coefficients de filtre permet de calculer les coefficients complexes du filtre numérique à synthétiser.

La procédure d'identification du filtre numérique complexe selon l'invention, permettant de supprimer les distorsions résiduelles induites par un fonctionnement d'amplificateur en classe G, est effectuée à chaque itération du système d'extraction.

De ce fait, les coefficients du filtre numérique sont mis à jour au fil des itérations jusqu'à atteindre des performances en linéarité en accord avec les normes des signaux à émettre. Cette méthode permet d'affiner au cours du temps les coefficients du filtre numérique complexe et ainsi d'obtenir des performances accrues en linéarité de l'amplificateur de puissance RF fonctionnant en classe G, mais également de tenir compte des variations des conditions de fonctionnement de l'amplificateur de puissance telles qu'une désadaptation d'antenne ou des variations de température.

Le filtre numérique complexe associé à son processus d'extraction permet principalement de supprimer les distorsions résiduelles induites par le fonctionnement en classe G de l'amplificateur de puissance préalablement linéarisé par un module de pré-distorsion numérique. Il permet par ailleurs de réaligner temporellement finement le signal radiofréquence généré en entrée de l'amplificateur de puissance vis-à-vis du signal de commande d'alimentation de l'amplificateur de puissance de classe G. En effet, si un faible décalage temporel existe entre le signal de commande d'alimentation et le signal généré en sortie du module de pré-distorsion numérique, il est automatiquement corrigé par le filtre numérique complexe.

Selon une caractéristique particulière de l'invention, le filtre numérique à coefficients complexes est réalisé à l'aide de plusieurs filtres à réponse impulsionnelle finie (FIR).

La sortie *y* du filtre numérique de type FIR s'exprime de la manière suivante en fonction du signal d'entrée *x* :

$$y(n) = \sum_{k=0}^{M-1} C(k) \times x(n-k)$$

où *M* est le nombre de coefficients du filtre numérique et *C(k)* sont les coefficients complexes du filtre numérique.

L'implantation directe d'un tel filtre dans un circuit numérique programmable est impossible car un filtre FIR possède nécessairement des coefficients qui sont des nombres réels. L'implantation du filtre numérique dans un circuit numérique est réalisée en mettant en œuvre différentes architectures équivalentes à un filtre FIR à coefficients complexes.

Les coefficients du filtre numérique sont calculés par le module d'extraction de coefficients de filtre de telle manière à minimiser l'erreur quadratique entre la réponse fréquentielle à synthétiser et la réponse fréquentielle du filtre FIR à coefficients complexes synthétisée.

Selon un premier mode de réalisation de l'invention, le filtre numérique à coefficients complexes comprend deux premiers filtres FIR identiques dont les coefficients correspondent à la partie réelle des coefficients complexes du filtre numérique à coefficients complexes, deux seconds filtres FIR identiques dont les coefficients correspondent à la partie imaginaire des coefficients complexes du filtre numérique à coefficients complexes, un additionneur et un soustracteur, l'un des premiers filtres FIR, recevant en entrée la composante I du signal de sortie du module de pré-distorsion numérique, et l'un des seconds filtres FIR, recevant en entrée la composante Q du signal de sortie du module de pré-distorsion numérique, étant reliés en sortie au soustracteur de manière à créer la composante I du signal de sortie du filtre numérique à coefficients complexes, l'autre des premiers filtres FIR, recevant en entrée la composante Q du signal de sortie du module de pré-distorsion numérique, et l'autre des seconds filtres FIR, recevant en entrée la composante I du signal de sortie du module de pré-distorsion numérique, étant reliés en sortie à l'additionneur de manière à créer la composante Q du signal de sortie du filtre numérique à coefficients complexes.

Ainsi, cette implémentation de filtre numérique à coefficients complexes consiste en l'utilisation de quatre filtres numériques de type FIR identiques deux à deux, d'un additionneur et d'un soustracteur.

Selon un second mode de réalisation de l'invention, le filtre numérique à coefficients complexes comprend un premier filtre FIR dont les coefficients correspondent à la somme des parties réelle et imaginaire des coefficients du filtre numérique à coefficients complexes, un second filtre FIR dont les coefficients correspondent à la partie imaginaire des coefficients du filtre numérique à coefficients complexes, un troisième filtre FIR dont les coefficients correspondent à la différence entre la partie réelle et la partie imaginaire des coefficients du filtre numérique à coefficients complexes, deux additionneurs et un soustracteur, le premier filtre FIR recevant en entrée la composante I du signal de sortie du module de pré-distorsion numérique, le troisième filtre FIR recevant en entrée la composante Q du signal de sortie du module de pré-distorsion numérique, le second filtre FIR recevant en entrée la somme des composantes I et Q du signal de sortie du module de pré-distorsion numérique par l'intermédiaire de l'un des additionneurs, les sorties des premier et second filtres FIR étant reliées au soustracteur de manière à créer la composante I du signal de sortie du filtre numérique à coefficients complexes, et les sorties des second et troisième filtres FIR étant reliées à l'autre des additionneurs de manière à créer la composante Q du signal de sortie du filtre numérique à coefficients complexes.

Ainsi, cette mise en œuvre alternative consiste en l'utilisation de trois filtres numériques tous différents, de deux additionneurs et d'un soustracteur.

Il est également possible d'utiliser d'autres structures alternatives utilisant trois filtres FIR afin de produire un filtre FIR à coefficients complexes.

La présente invention a également pour objet un système pour la technique de suivi d'enveloppe comprenant un système de linéarisation en bande de base tel que décrit ci-dessus, un amplificateur de puissance RF de classe G, un convertisseur continu-continu, un convertisseur analogique-numérique, un convertisseur numérique-analogique, un mélangeur élévateur de fréquence et un mélangeur abaisseur de fréquence, le convertisseur continu-continu étant disposé entre la seconde sortie du système de linéarisation et l'entrée d'alimentation de l'amplificateur de puissance, le convertisseur numérique-analogique et le mélangeur élévateur de fréquence étant disposés en série entre la première sortie du système de linéarisation et l'entrée RF de l'amplificateur de puissance, le mélangeur abaisseur de fréquence et le convertisseur analogique-numérique étant disposés en série entre la sortie de l'amplificateur de puissance et la seconde entrée du système de linéarisation.

Ainsi, le signal numérique de linéarisation est converti en une grandeur analogique à l'aide du convertisseur numérique-analogique sur les voies en phase et en quadrature.

Le signal en bande de base analogique est ensuite transposé autour de la fréquence porteuse radiofréquence par le mélangeur élévateur de fréquence. Le signal généré est enfin injecté à l'entrée de l'amplificateur de puissance RF de classe G suivant différents étages de gain selon la topologie de la chaîne d'amplification.

Afin d'extraire les paramètres de linéarisation, c'est-à-dire les coefficients du module de pré-distorsion numérique et les coefficients du filtrage numérique, une partie du signal en sortie de l'amplificateur de puissance est prélevée puis transposée en bande de base par le mélangeur abaisseur de fréquence, avant d'être numérisée à l'aide du convertisseur analogique-numérique.

Le convertisseur continu-continu permet de fournir à l'amplificateur de puissance l'une des tensions d'alimentation discrètes en fonction du signal de sélection de tension d'alimentation issu du système de linéarisation.

Le module d'extraction de coefficients de filtre a besoin de plusieurs itérations pour extraire les coefficients du filtre. Ce processus d'extraction peut toutefois s'exécuter de manière continue afin de prévenir tout changement des conditions de fonctionnement de l'amplificateur de puissance RF de classe G.

Pour mieux illustrer l'objet de la présente invention, on va en décrire ci-après, à titre illustratif et non limitatif, deux modes de réalisation préférés, avec référence aux dessins annexés.

Sur ces dessins :

[Fig.1] représente un schéma fonctionnel d'un système pour la technique de suivi d'enveloppe comprenant un système de linéarisation en bande de base selon une première variante de l'invention ;

[Fig.2] représente un schéma fonctionnel d'un système pour la technique de suivi d'enveloppe comprenant un système de linéarisation en bande de base selon une seconde variante de l'invention ;

[Fig.3] représente un schéma fonctionnel du module de pré-distorsion numérique du système de linéarisation de la Figure 1 ;

[Fig.4] représente un schéma fonctionnel du module de pré-distorsion numérique du système de linéarisation de la Figure 2 ;

[Fig.5] représente un schéma de principe du module de pré-distorsion numérique du système de linéarisation de la Figure 1 ;

[Fig.6] représente un schéma de principe du module de pré-distorsion numérique du système de linéarisation de la Figure 2 ;

[Fig.7] représente un schéma fonctionnel du module d'extraction de coefficients de pré-distorsion du système de linéarisation selon la présente invention ;

[Fig.8] représente un schéma fonctionnel du module d'extraction de coefficients de filtre du système de linéarisation selon la présente invention ;

[Fig.9] représente un schéma fonctionnel du filtre numérique à coefficients complexes du système de linéarisation selon un premier mode de réalisation de l'invention ;

[Fig.10] représente un schéma fonctionnel du filtre numérique à coefficients complexes du système de linéarisation selon un second mode de réalisation de l'invention ;

[Fig.11] est un graphique à titre d'exemple représentant le module du gain de la pré-distorsion à générer pour linéariser un amplificateur de puissance RF de classe G ;

[Fig.12] est un graphique à titre d'exemple représentant le module du gain du filtre numérique à coefficients complexes à synthétiser ;

[Fig.13] est un graphique à titre d'exemple représentant la phase du gain du filtre numérique à coefficients complexes à synthétiser ; et

[Fig.14] est un graphique à titre d'exemple représentant les spectres de sortie de l'amplificateur de puissance RF de classe G avec et sans le système de linéarisation de la présente invention.

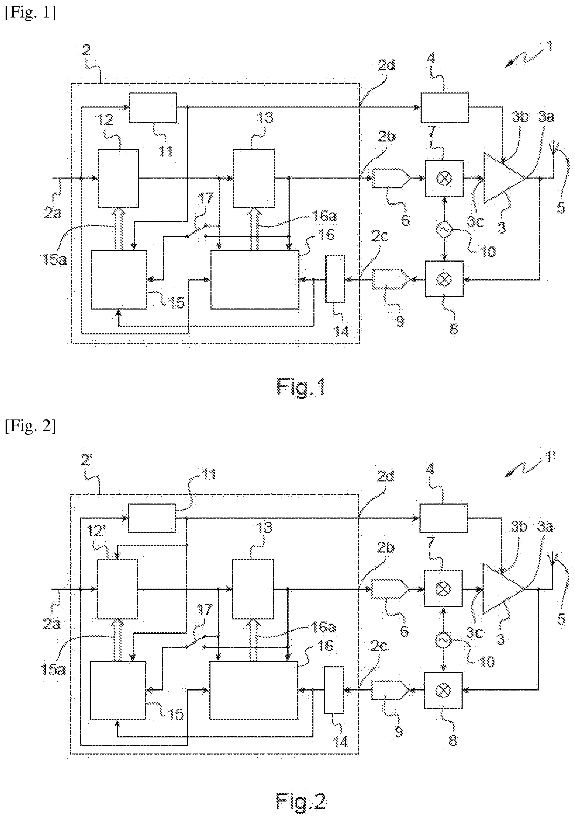

Si l'on se réfère à la Figure 1, on peut voir qu'il y est représenté un système pour la technique de suivi d'enveloppe 1 comprenant un système de linéarisation en bande de base 2 selon une première variante de l'invention.

Le système pour la technique de suivi d'enveloppe 1 comprend un système de linéarisation en bande de base 2, un amplificateur de puissance RF de classe G 3 et un convertisseur continu-continu 4.

Le système de linéarisation 2 comprend une première entrée 2a apte à recevoir un signal numérique en bande de base d'entrée à émettre comprenant une composante en phase, I, et une composante en quadrature, Q ; une première sortie 2b apte à délivrer un signal numérique en bande de base de sortie linéarisé à destination de l'amplificateur de puissance RF de classe G 3 ; une seconde entrée 2c apte à recevoir un signal numérique en bande de base provenant de la sortie 3a de l'amplificateur de puissance RF 3 ; et une seconde sortie 2d apte à délivrer un signal numérique de sélection de tension d'alimentation à destination du convertisseur continu-continu 4 relié à l'entrée d'alimentation 3b de l'amplificateur de puissance RF de classe G 3.

Le convertisseur continu-continu 4 permet de fournir à l'amplificateur de puissance RF de classe G 3 l'une d'une pluralité de tensions d'alimentation discrètes en fonction du signal de sélection de tension d'alimentation issu de la seconde sortie 2d du système de linéarisation 2.

La sortie 3a de l'amplificateur de puissance RF 3 est en outre reliée à une antenne d'émission 5.

Le système pour la technique de suivi d'enveloppe 1 comprend en outre un convertisseur numérique-analogique 6 et un mélangeur élévateur de fréquence 7 disposés en série entre la première sortie 2b du système de linéarisation 2 et l'entrée RF 3c de l'amplificateur de puissance RF 3.

Ainsi, le signal numérique en bande de base de sortie linéarisé issu de la première sortie 2b du système de linéarisation 2 est converti en une grandeur analogique par le convertisseur numérique-analogique 6 sur les voies I et Q, puis transposé autour de la fréquence porteuse radiofréquence par le mélangeur élévateur de fréquence 7, le signal généré étant enfin injecté à l'entrée 3c de l'amplificateur de puissance RF 3.

Le système pour la technique de suivi d'enveloppe 1 comprend en outre un mélangeur abaisseur de fréquence 8 et un convertisseur analogique-numérique 9 disposés en série entre la sortie 3a de l'amplificateur de puissance RF 3 et la seconde entrée 2c du système de linéarisation 2.

Ainsi, une partie du signal en sortie 3a de l'amplificateur de puissance RF 3 est prélevée puis transposée en bande de base par le mélangeur abaisseur de fréquence 8, avant d'être convertie en une grandeur numérique à l'aide du convertisseur analogique-numérique 9.

Le système pour la technique de suivi d'enveloppe 1 comprend en outre un oscillateur local 10 relié au mélangeur élévateur de fréquence 7 et au mélangeur abaisseur de fréquence 8.

Le système de linéarisation 2 comprend un module de sélection de tension d'alimentation d'amplificateur 11 dont l'entrée est reliée à la première entrée 2a du système de linéarisation 2 et dont la sortie est reliée à la seconde sortie 2d du système de linéarisation 2, ledit module de sélection de tension d'alimentation d'amplificateur 11 étant configuré pour sélectionner une tension d'alimentation parmi au moins deux tensions d'alimentation continues en fonction de l'amplitude du signal d'entrée à émettre reçu au niveau de la première entrée 2a du système de linéarisation 2.

Le nombre maximal de tensions d'alimentation continues est, de préférence, égal à 16.

Le système de linéarisation 2 comprend en outre un module de pré-distorsion numérique à une dimension 12 relié à la première entrée 2a du système de linéarisation 2 et configuré pour réaliser une pré-distorsion numérique des composantes I et Q du signal d'entrée à émettre reçu au niveau de la première entrée 2a du système de linéarisation 2.

Le module de pré-distorsion numérique 12 utilisé pour la linéarisation s'appuie sur une pré-distorsion numérique en bande de base qui est une fonction non linéaire correspondant à la fonction de transfert inverse de l'amplificateur de puissance 3 à linéariser. La mise en œuvre du module de pré-distorsion numérique 12 nécessite des ressources numériques limitées et permet d'atteindre une très nette amélioration des performances en linéarité de l'amplificateur de puissance 3.

Le système de linéarisation 2 comprend en outre un filtre numérique à coefficients complexes 13 dont l'entrée est reliée à la sortie du module de pré-distorsion numérique 12 et dont la sortie est reliée à la première sortie 2b du système de linéarisation 2.

Le filtre numérique à coefficients complexes 13 permet d'annuler les distorsions générées dans la bande du signal modulé et dans les canaux adjacents. Il permet par ailleurs d'annuler le bruit spectral généré par les distorsions lors de chaque changement de niveau d'alimentation de l'amplificateur de puissance RF de classe G 3. L'annulation du bruit spectral est réalisée sur toute la bande passante instantanée de génération du signal RF.

La réponse fréquentielle du filtre numérique à coefficients complexes 13 est, de préférence, dissymétrique entre les fréquences positives et négatives.

Ainsi, en sortie du module de pré-distorsion numérique 12, l'insertion dans la chaîne de traitement des données en phase et en quadrature (I et Q) en bande de base du filtre numérique 13 a pour rôle de distordre le spectre du signal de linéarisation issu du module de pré-distorsion numérique 12 afin d'annuler les distorsions spectrales résiduelles, le filtre numérique 13 étant un filtre numérique à coefficients complexes, c'est-à-dire dont les coefficients présentent à la fois une partie réelle et une partie imaginaire.

Le système de linéarisation 2 comprend en outre un module d'alignement 14 relié à la seconde entrée 2c du système de linéarisation 2, ledit module d'alignement 14 étant configuré pour aligner en amplitude et en phase le signal numérique en bande de base provenant de la sortie 3a de l'amplificateur de puissance RF 3 avec les autres signaux numériques en bande de base du système de linéarisation 2.

Le système de linéarisation 2 comprend en outre un module d'extraction de coefficients de pré-distorsion 15 configuré pour extraire des coefficients de pré-distorsion 15a utilisés par le module de pré-distorsion numérique 12.

Les coefficients de pré-distorsion 15a sont extraits par le module d'extraction de coefficients de pré-distorsion 15 en fonction de la sortie du module d'alignement 14 (c'est-à-dire de la sortie 3a de l'amplificateur de puissance 3), de la sortie du module de pré-distorsion numérique 12 et de la sortie du module de sélection de tension d'alimentation d'amplificateur 11 (c'est-à-dire de la tension d'alimentation sélectionnée).

Il est à noter que les coefficients de pré-distorsion 15a pourraient également être extraits en fonction de la sortie du filtre numérique à coefficients complexes 13 au lieu de la sortie du module de pré-distorsion numérique 12, sans s'écarter du cadre de la présente invention, un commutateur 17 ayant été représenté à la Figure 1 afin d'illustrer ces deux alternatives.

Pour chacune des tensions d'alimentation appliquées à l'amplificateur de puissance 3, des coefficients de pré-distorsion 15a sont extraits de manière indépendante, les coefficients de pré-distorsion 15a extraits étant affinés au fil d'extractions successives.

Le système de linéarisation 2 comprend en outre un module d'extraction de coefficients de filtre 16 configuré pour extraire des coefficients de filtre 16a utilisés par le filtre numérique à coefficients complexes 13.

Les coefficients de filtre 16a sont extraits par le module d'extraction de coefficients de filtre 16 en fonction des composantes I et Q du signal à émettre issu de la première entrée 2a du système de linéarisation 2, de la sortie du module d'alignement 14 (c'est-à-dire de la sortie 3a de l'amplificateur de puissance 3), de la sortie du filtre numérique à coefficients complexes 13 et de la sortie du module de pré-distorsion numérique 12.

L'extraction des coefficients de filtre 16a est ainsi réalisée à partir de la mesure du signal de sortie de l'amplificateur de puissance 3 lorsque le module de pré-distorsion numérique 12 est préalablement appliqué. L'optimisation des coefficients de filtre 16a s'effectue de manière itérative, c'est-à-dire que les valeurs des coefficients de filtre 16a sont affinées au fil des déterminations successives.

Si l'on se réfère à la Figure 2, on peut voir qu'il y est représenté un système pour la technique de suivi d'enveloppe 1' comprenant un système de linéarisation en bande de base 2' selon une seconde variante de l'invention.

Les éléments communs entre la première variante de l'invention sur la Figure 1 et cette seconde variante de l'invention portent le même chiffre de référence, et ne seront pas décrits plus en détail ici lorsqu'ils sont de structures identiques.

Le système pour la technique de suivi d'enveloppe 1' selon la seconde variante est identique au système pour la technique de suivi d'enveloppe 1 selon la première variante à l'exception du fait que, dans la seconde variante, le module de pré-distorsion numérique 12' du système de linéarisation 2' est configuré pour réaliser une pré-distorsion numérique à deux dimensions.

Le module de pré-distorsion numérique à deux dimensions 12' comprend deux entrées respectivement reliées à la première entrée 2a du système de linéarisation 2' et à la sortie du module de sélection de tension d'alimentation d'amplificateur 11.

Le module de pré-distorsion numérique 12' est ainsi configuré pour réaliser une pré-distorsion numérique en fonction de l'amplitude des composantes I et Q du signal à émettre et de la tension d'alimentation sélectionnée par le module de sélection de tension d'alimentation d'amplificateur 11.

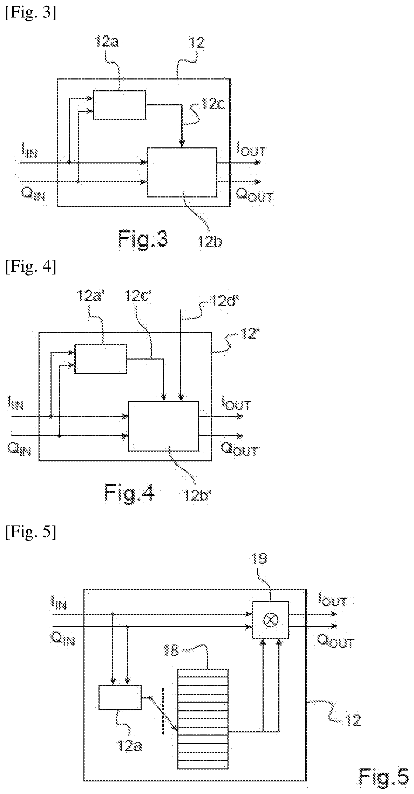

Si l'on se réfère à la Figure 3, on peut voir qu'il y est représenté le module de pré-distorsion numérique 12 du système de linéarisation 2 selon la première variante de l'invention.

Selon la première variante de l'invention, le module de pré-distorsion numérique 12 est configuré pour réaliser une pré-distorsion numérique à une dimension en fonction de l'amplitude des composantes I et Q du signal à émettre.

Dans le cas du module de pré-distorsion numérique à une dimension 12, le facteur de pré-distorsion à appliquer est uniquement dépendant du module du signal complexe numérique en bande de base.

Le module de pré-distorsion numérique à une dimension 12 comprend deux entrées $I_{IN}$ et $Q_{IN}$, recevant respectivement les composantes I et Q du signal à émettre, et deux sorties $I_{OUT}$ et $Q_{OUT}$.

Le module de pré-distorsion numérique à une dimension 12 comprend une unité de calcul de module 12a configurée pour calculer le module 12c du signal à émettre à partir des données reçues sur les entrées $I_{IN}$ et $Q_{IN}$.

Le module de pré-distorsion numérique à une dimension 12 comprend en outre une unité de pré-distorsion numérique à une dimension (1D) 12b configurée pour réaliser une pré-distorsion numérique sur les données reçues sur les entrées $I_{IN}$ et $Q_{IN}$ en fonction du module 12c calculé par l'unité de calcul de module 12a, les composantes I et Q linéarisées du signal à émettre étant délivrées sur les sorties $I_{OUT}$ et $Q_{OUT}$.

Si l'on se réfère à la Figure 4, on peut voir qu'il y est représenté le module de pré-distorsion numérique 12' du système de linéarisation 2' selon la seconde variante de l'invention.

Selon la seconde variante de l'invention, le module de pré-distorsion numérique 12' est configuré pour réaliser une pré-distorsion numérique à deux dimensions en fonction de l'amplitude des composantes I et Q du signal à émettre et en fonction de la tension d'alimentation appliquée à l'amplificateur de puissance RF de classe G 3.

Le module de pré-distorsion numérique à deux dimensions 12' comprend deux entrées $I_{IN}$ et $Q_{IN}$, recevant respectivement les composantes I et Q du signal à émettre, une entrée supplémentaire 12d', recevant le signal de sélection de tension d'alimentation délivré par le module de sélection de tension d'alimentation d'amplificateur 11, et deux sorties $I_{OUT}$ et $Q_{OUT}$.

Le module de pré-distorsion numérique à deux dimensions 12' comprend une unité de calcul de module 12a' configurée pour calculer le module 12c' du signal à émettre à partir des données reçues sur les entrées $I_{IN}$ et $Q_{IN}$.

Le module de pré-distorsion numérique à deux dimensions 12' comprend en outre une unité de pré-distorsion numérique à deux dimensions (2D) 12b' configurée pour réaliser une pré-distorsion numérique sur les données reçues sur les entrées $I_{IN}$ et $Q_{IN}$ en fonction du module 12c' calculé par l'unité de calcul de module 12a' et en fonction du signal de sélection de tension d'alimentation reçu sur l'entrée supplémentaire 12d', les composantes I et Q linéarisées du signal à émettre étant délivrées sur les sorties $I_{OUT}$ et $Q_{OUT}$.

Si l'on se réfère à la Figure 5, on peut voir qu'il y est représenté le module de pré-distorsion numérique 1D 12 du système de linéarisation 2 selon la première variante de l'invention.

La réalisation du module de pré-distorsion numérique 1D 12 à base d'une table de correspondance est décrite à la Figure 5 dans le cas d'une pré-distorsion numérique de type polynomiale sans mémoire.

Dans le cas d'une réalisation du module de pré-distorsion numérique 1D 12 par une table de correspondance, les coefficients de pré-distorsion sont stockés dans une mémoire 18 et indexés en fonction du module de signal à émettre calculé par l'unité de calcul de module 12a, un multiplieur complexe 19 permettant d'appliquer les coefficients de pré-distorsion sélectionnés aux composantes I et Q du signal à émettre.

Le module de pré-distorsion numérique 1D 12 pourrait également s'appuyer sur une pré-distorsion numérique en bande de base à partir de fonctions mathématiques non-linéaires par exemple de type polynomiale à mémoire ou série de Volterra, sans s'écarter du cadre de la présente invention.

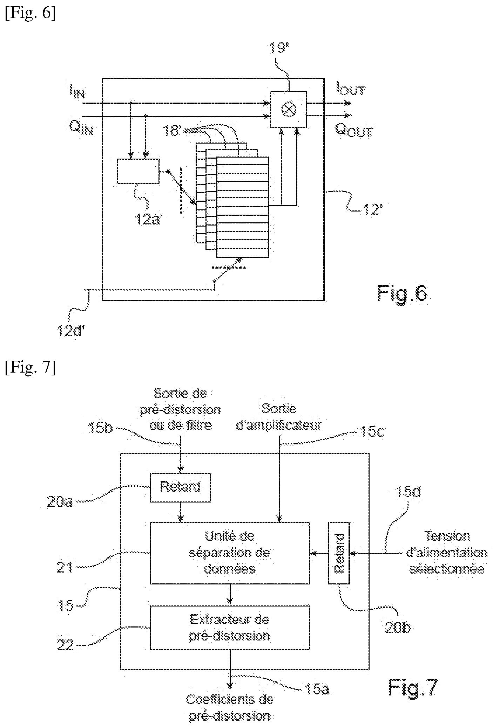

Si l'on se réfère à la Figure 6, on peut voir qu'il y est représenté le module de pré-distorsion numérique 2D 12' du système de linéarisation 2' selon la seconde variante de l'invention.

La réalisation du module de pré-distorsion numérique 2D 12' à base de tables de correspondance est décrite à la Figure 6 dans le cas d'une pré-distorsion numérique de type polynomiale sans mémoire pour un amplificateur de puissance de classe G 3 pouvant prendre trois niveaux de tension d'alimentation.

Dans le cas d'une réalisation du module de pré-distorsion numérique 2D 12' par des tables de correspondance, les coefficients de pré-distorsion sont stockés dans plusieurs mémoires 18', chaque mémoire 18' correspondant à une tension d'alimentation de l'amplificateur de puissance de classe G 3.

Dans chaque mémoire 18', les coefficients de pré-distorsion sont indexés en fonction du module de signal à émettre calculé par l'unité de calcul de module 12a', un multiplieur complexe 19' permettant d'appliquer les coefficients de pré-distorsion sélectionnés aux composantes I et Q du signal à émettre.

Le module de pré-distorsion numérique 2D 12' pourrait également s'appuyer sur une pré-distorsion numérique en bande de base à partir de fonctions mathématiques non-linéaires par exemple de type polynomiale à mémoire ou série de Volterra, sans s'écarter du cadre de la présente invention.

Si l'on se réfère à la Figure 7, on peut voir qu'il y est représenté le module d'extraction de coefficients de pré-distorsion 15 du système de linéarisation 2 selon la présente invention.

Le module d'extraction de coefficients de pré-distorsion 15 comprend une sortie 15a délivrant les coefficients de pré-distorsion au module de pré-distorsion numérique 12, une première entrée 15b recevant l'une parmi la sortie du module de pré-distorsion numérique 12 et la sortie du filtre numérique 13 en fonction de la position du commutateur 17, une seconde entrée 15C recevant la sortie du module d'alignement 14 (correspondant à la sortie 3a de l'amplificateur de puissance 3), et une troisième entrée 15d recevant la sortie du module de sélection de tension d'alimentation d'amplificateur 11.

Le module d'extraction de coefficients de pré-distorsion 15 comprend des première et seconde unités de retard temporel 20a, 20b, une unité de séparation de données 21 et une unité d'extraction de coefficients de pré-distorsion 22.

La première unité de retard temporel 20a est configurée pour compenser le temps de propagation et de traitement du signal issu de l'un parmi le filtre numérique à coefficients complexes 13 et le module de pré-distorsion numérique 12.

La seconde unité de retard temporel 20b est configurée pour compenser le temps de propagation et de traitement du signal issu de la sortie du module de sélection de tension d'alimentation d'amplificateur 11.

L'unité de séparation de données 21 est configurée pour séparer et stocker dans une mémoire les données concernant le signal numérique en bande de base provenant de la sortie du module d'alignement 14 (correspondant à la sortie 3a de l'amplificateur de puissance 3) et le signal retardé issu de l'un parmi le filtre numérique à coefficients complexes 13 et le module de pré-distorsion numérique 12 en fonction du signal retardé de sélection de tension d'alimentation délivré par le module de sélection de tension d'alimentation d'amplificateur 11. Dans le cas de l'amplification de classe G, le nombre de tensions d'alimentation possibles étant très faible, cette tâche est sans complexité et nécessite peu de ressources numériques.

L'unité d'extraction de coefficients de pré-distorsion 22 est configurée pour extraire, pour chaque tension d'alimentation possible de l'amplificateur de puissance 3, les coefficients de pré-distorsion associés à partir des données stockées en mémoire par l'unité de séparation de données 21. Les coefficients de pré-distorsion extraits, pour chaque tension d'alimentation discrète, sont ensuite chargés différemment dans le module de pré-distorsion numérique 12, 12' suivant qu'il s'agit d'une pré-distorsion numérique à une ou deux dimensions. Dans le cas du module de pré-distorsion numérique 12, 12' mis en œuvre à l'aide de tables de correspondance, les coefficients de pré-distorsion sont stockés dans une seule zone mémoire 18 si le module de pré-distorsion numérique 12 est à une dimension ou bien dans autant de zones mémoires 18' que de tensions d'alimentation utilisées si le module de pré-distorsion numérique 12' est à deux dimensions.

Le processus d'extraction des coefficients de pré-distorsion s'effectue à intervalles de temps prédéterminés afin d'affiner au cours du temps les coefficients de pré-distorsion et ainsi d'obtenir des performances accrues en linéarité de l'amplificateur de puissance de classe G 3. Le processus d'extraction continu des coefficients de pré-distorsion permet également de tenir compte des variations des conditions de fonctionnement de l'amplificateur de puissance 3 telles qu'une désadaptation d'antenne ou des variations de température.

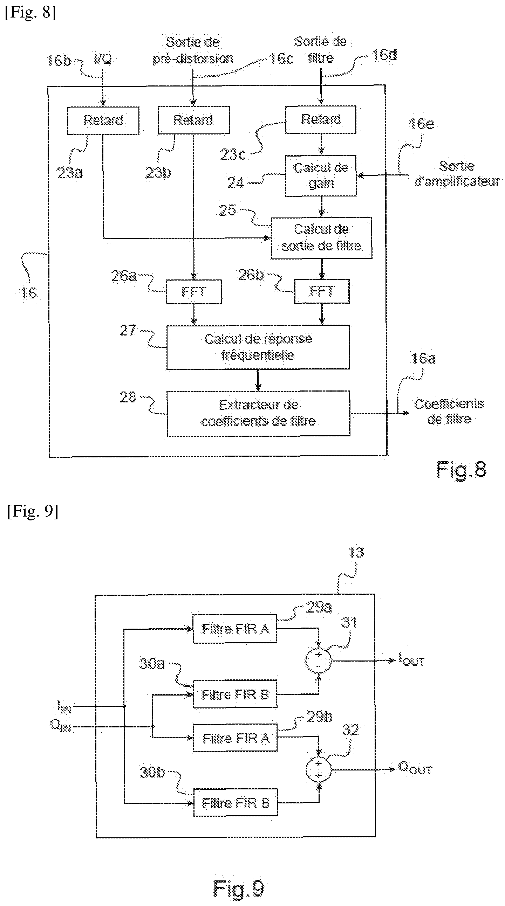

Si l'on se réfère à la Figure 8, on peut voir qu'il y est représenté le module d'extraction de coefficients de filtre 16 du système de linéarisation 2 selon la présente invention.

Le module d'extraction de coefficients de filtre 16 comprend une sortie 16a délivrant les coefficients de filtre au filtre numérique à coefficients complexes 13, une première entrée 16b recevant les composantes I et Q du signal d'entrée à émettre, une seconde entrée 16c recevant la sortie du module de pré-distorsion 12, une troisième entrée 16d recevant la sortie du filtre numérique à coefficients complexes 13 et une quatrième entrée 16e recevant la sortie du module d'alignement 14 (correspondant à la sortie 3a de l'amplificateur de puissance 3).

Le module d'extraction de coefficients de filtre 16 comprend trois unités de retard temporel 23a, 23b, 23c, une unité de calcul de gain 24, une unité de calcul de signal attendu de sortie de filtre 25, deux unités de transformée de Fourrier rapide (FFT) 26a, 26b, une unité de calcul de réponse fréquentielle de filtre 27 et une unité d'extraction de coefficients de filtre 28.

Les trois unités de retard temporel 23a, 23b, 23c sont respectivement configurées pour compenser les temps de propagation et de traitement des composantes I et Q du signal à émettre, de la sortie du module de pré-distorsion numérique 12 et de la sortie du filtre numérique à coefficients complexes 13.

L'unité de calcul de gain 24 est configurée pour calculer le gain complexe de l'amplificateur de puissance 3 à partir de la sortie retardée du filtre numérique à coefficients complexes 13 et du signal numérique en bande de base provenant de la sortie du module d'alignement 14 (correspondant à la sortie 3a de l'amplificateur de puissance 3).

L'unité de calcul de signal attendu de sortie de filtre 25 est configurée pour calculer le signal à générer par le filtre numérique 13 à partir du gain complexe calculé par l'unité de calcul de gain 24 et des composantes I et Q retardées du signal à émettre.

Les deux unités FFT 26a, 26b sont respectivement configurées pour calculer les transformées de Fourrier rapides de la sortie retardée du module de pré-distorsion numérique 12 et du signal à générer par le filtre numérique 13 calculé par l'unité de calcul de signal attendu de sortie de filtre 25.

L'unité de calcul de réponse fréquentielle de filtre 27 est configurée pour calculer la réponse fréquentielle du filtre numérique 13 à générer à partir des deux transformées de Fourrier rapides calculées par les deux unités FFT 26a, 26b.

L'unité d'extraction de coefficients de filtre 28 est configurée pour extraire les coefficients complexes du filtre numérique 13 à synthétiser en fonction de la réponse fréquentielle calculée par l'unité de calcul de réponse fréquentielle de filtre 27.

Il est à noter que le module de pré-distorsion numérique 12 doit obligatoirement avoir préalablement été appliqué avant de procéder à l'extraction des coefficients du filtre numérique complexe 13.

Initialement, au démarrage du processus d'identification, aucun filtrage n'est appliqué en sortie du module de pré-distorsion numérique 12. Si aucun filtrage n'est appliqué, le filtre numérique complexe 13 prend alors un gain unitaire au démarrage du processus d'identification.

L'unité de calcul de gain 24 permet de calculer le gain complexe de l'amplificateur de puissance 3 à chaque instant d'échantillonnage selon l'équation :

$$Gain\ (n) = \frac{Amplifier\ OUT\ (n),}{FLT\ OUT\ (n)}$$

où *n* est l'indice de l'échantillon, *Amplifier OUT* est le signal de sortie de l'amplificateur de puissance 3 et *FLT OUT* est le signal de sortie du filtre numérique à coefficients complexes 13.

Dans l'unité de calcul de sortie de filtre 25, le nouveau signal de linéarisation à générer est calculé pour chaque instant d'échantillonnage afin d'annuler les distorsions spectrales résiduelles selon l'équation :

$$New \ FLT \ OUT\left(n\right) = \frac{Original \ Waveform \ (n),}{Gain \ (n)}$$

où $n$ est l'indice de l'échantillon, *Original Waveform* est le signal d'origine à émettre et *New FLT OUT* est la nouvelle sortie du filtre numérique à coefficients complexes 13 à générer.

Dans les unités FFT 26a, 26b, les transformées de Fourrier du nouveau signal de linéarisation à générer calculé précédemment et du signal issu du module de pré-distorsion numérique 12 sont calculées sur un nombre d'échantillons prédéfinis selon les équations :

$$New \ FLT \ OUT_{spectrum}(f) = TFD\left[New \ FLT \ OUT \ (n)\right]$$

,

$$DPD \ OUT_{spectrum}(f) = TFD\left[DPD \ OUT \ (n)\right],$$

où *TFD* désigne la fonction de transformée de Fourrier discrète d'un signal échantillonné, cette fonction étant mise en œuvre à l'aide d'un algorithme de transformée de Fourrier rapide (FFT), $f$ désigne l'indice de l'échantillon après transformée de Fourrier, *DPD OUT* est la sortie du module de pré-distorsion numérique 12, *New FLT OUT* $_{spectrum}$ est la transformée de Fourrier de la nouvelle sortie de filtre 13 à générer *et DPD OUT* $_{spectrum}$ est la transformée de Fourrier de la sortie du module de pré-distorsion numérique 12.

La réponse fréquentielle H du filtre numérique 13 à générer est ensuite estimée dans l'unité de calcul de réponse fréquentielle de filtre 27 selon l'équation :

$$H\left(f\right) = \frac{New \ FLT \ OUT_{spectrum}\left(f\right),}{DPD \ OUT_{spectrum}(f)}$$

où $f$ est l'indice de l'échantillon après transformée de Fourrier, cet indice correspondant à un indice de fréquence.

Enfin, l'unité d'extraction de coefficients de filtre 28 permet de calculer les coefficients complexes du filtre numérique 13 à synthétiser.

Le calcul des coefficients de filtre est réalisé de manière itérative à intervalles de temps prédéterminés, les coefficients de filtre étant affinés au fil des itérations successives. Le module d'extraction de coefficients de filtre 16 a en effet besoin de plusieurs itérations pour extraire les coefficients du filtre.

Les coefficients du filtre numérique 13 sont mis à jour au fil des itérations jusqu'à atteindre des performances en linéarité en accord avec les normes des signaux à émettre. Cette méthode permet d'affiner au cours du temps les coefficients du filtre numérique complexe 13 et ainsi d'obtenir des performances accrues en linéarité de l'amplificateur de puissance RF de classe G 3, mais également de tenir compte des variations des conditions de fonctionnement de l'amplificateur de puissance 3 telles qu'une désadaptation d'antenne ou des variations de température.

Si l'on se réfère à la Figure 9, on peut voir qu'il y est représenté le filtre numérique à coefficients complexes 13 du système de linéarisation 2 selon un premier mode de réalisation de l'invention.

La sortie y du filtre numérique à coefficients complexes 13 s'exprime de la manière suivante en fonction du signal d'entrée x :

$$y\left(n\right) = \sum_{k=0}^{M-1} C\left(k\right) \times x(n-k)$$

où $M$ est le nombre de coefficients du filtre numérique 13 et $C(k)$ sont les coefficients complexes du filtre numérique 13.

L'implantation directe d'un tel filtre 13 dans un circuit numérique programmable est impossible car un filtre FIR possède nécessairement des coefficients qui sont des nombres réels. L'implantation du filtre numérique 13 dans un circuit numérique est réalisée en mettant en œuvre différentes architectures équivalentes à un filtre FIR à coefficients complexes.

Selon le premier mode de réalisation, le filtre numérique à coefficients complexes 13 comprend deux premiers filtres à réponse impulsionnelle finie (FIR) A 29a, 29b identiques dont les coefficients correspondent à la partie réelle des coefficients complexes du filtre numérique à coefficients complexes 13, deux seconds filtres FIR B 30a, 30b identiques dont les coefficients correspondent à la partie imaginaire des coefficients complexes du filtre numérique à coefficients complexes 13, un soustracteur 31 et un additionneur 32.

Le filtre numérique à coefficients complexes 13 comprend deux entrées $I_{IN}$ et $Q_{IN}$, recevant respectivement les composantes I et Q du signal provenant de la sortie du module de pré-distorsion numérique 12, et deux sorties $I_{OUT}$ et $Q_{OUT}$, délivrant respectivement les composantes I et Q après filtrage.

Le premier filtre FIR A 29a reçoit en entrée la composante I du signal de sortie du module de pré-distorsion numérique 12.

Le second filtre FIR B 30a reçoit en entrée la composante Q du signal de sortie du module de pré-distorsion numérique 12.

Le premier filtre FIR A 29a et le second filtre FIR B 30a sont reliés en sortie au soustracteur 31 de manière à créer la composante I du signal de sortie $I_{OUT}$ du filtre numérique à coefficients complexes 13.

Le premier filtre FIR A 29b reçoit en entrée la composante Q du signal de sortie du module de pré-distorsion numérique 12.

Le second filtre FIR B 30b reçoit en entrée la composante I du signal de sortie du module de pré-distorsion numérique 12.

Le premier filtre FIR A 29b et le second filtre FIR B 30b sont reliés en sortie à l'additionneur 32 de manière à créer la composante Q du signal de sortie $Q_{OUT}$ du filtre numérique à coefficients complexes 13.

Ainsi, les premiers filtres FIR A 29a, 29b reçoivent comme coefficients la partie réelle des coefficients $C(k)$ du filtre numérique complexe 13 synthétisé notée $C_I(k)$ et les seconds filtres FIR B reçoivent comme coefficients la partie imaginaire des coefficients $C(k)$ du filtre numérique complexe 13 synthétisé notée $C_Q(k)$.

$$C(k) = C_I(k) + j \times C_Q(k),$$

où j est l'opérateur complexe.

Le signal de sortie en phase noté $I_{OUT}$ du filtre numérique 13 s'exprime de la manière suivante en fonction des données d'entrée en phase $I_{IN}$ et en quadrature $Q_{IN}$ :

$$I_{OUT}(n) = \sum_{k=0}^{M-1} C_I(k) \times I_{IN}(n-k) - \sum_{k=0}^{M-1} C_Q(k) \times Q_{IN}(n-k)$$

.

Le signal de sortie en quadrature noté $Q_{OUT}$ du filtre numérique 13 s'exprime de la manière suivante en fonction des données d'entrée en phase $I_{IN}$ et en quadrature $Q_{IN}$ :

$$Q_{OUT}(n) = \sum_{k=0}^{M-1} C_I(k) \times Q_{IN}(n-k) + \sum_{k=0}^{M-1} C_Q(k) \times I_{IN}(n-k)$$

.

Dans chaque cas, $M$ est le nombre de coefficients du filtre numérique 13, $C_I(k)$ et $C_Q(k)$ étant les coefficients respectifs des premiers filtres FIR A et des seconds filtres FIRB.

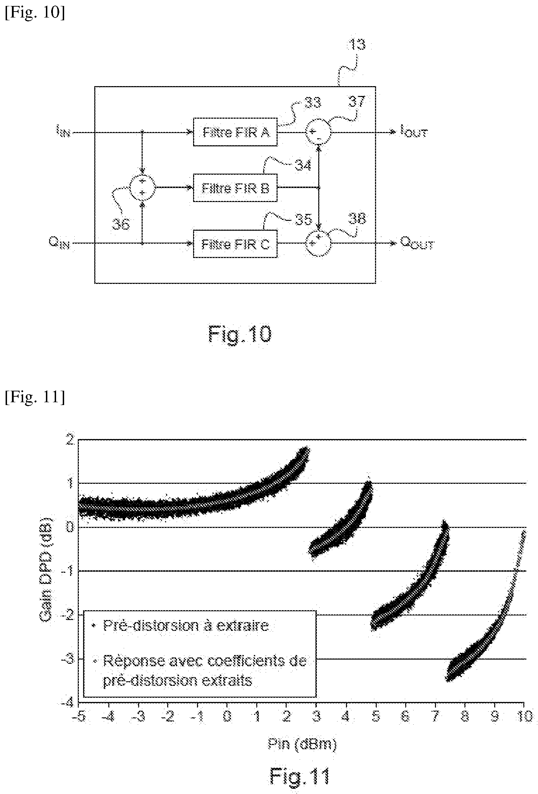

Si l'on se réfère à la Figure 10, on peut voir qu'il y est représenté le filtre numérique à coefficients complexes 13 du système de linéarisation 2 selon un second mode de réalisation de l'invention.

Selon le second mode de réalisation, le filtre numérique à coefficients complexes 13 comprend un premier filtre FIR A 33 dont les coefficients correspondent à la somme des parties réelle et imaginaire des coefficients du filtre numérique à coefficients complexes 13, un second filtre FIR B 34 dont les coefficients correspondent à la partie imaginaire des coefficients du filtre numérique à coefficients complexes 13, un troisième filtre FIR C 35 dont les coefficients correspondent à la différence entre la partie réelle et la partie imaginaire des coefficients du filtre numérique à coefficients complexes 13, deux additionneurs 36, 38 et un soustracteur 37.

Ainsi, le premier filtre FIR A 33 reçoit comme coefficients, notés $C_{Filter-A}(k)$, la somme de la partie réelle et imaginaire des coefficients $C(k)$ du filtre numérique 13 :

$$C_{Filter\_A}(k) = C_I(k) + C_Q(k).$$

Le second filtre FIR B 34 reçoit comme coefficients, notés $C_{Filter\_B}(k)$, la partie imaginaire des coefficients $C(k)$ du filtre numérique 13 :

$$C_{Filter\_B}(k) = C_Q(k).$$

Le troisième filtre FIR C 35 reçoit comme coefficients, notés $C_{Filter\_C}(k)$, la différence entre la partie réelle et imaginaire des coefficients $C(k)$ du filtre numérique 13 :

$$C_{Filter\_C}(k) = C_I(k) - C_Q(k).$$

Le filtre numérique à coefficients complexes 13 comprend deux entrées $I_{IN}$ et $Q_{IN}$, recevant respectivement les composantes I et Q du signal provenant de la sortie du module de pré-distorsion numérique 12, et deux sorties $I_{OUT}$ et $Q_{OUT}$, délivrant respectivement les composantes I et Q après filtrage.

Le premier filtre FIR A 33 reçoit en entrée la composante I du signal de sortie du module de pré-distorsion numérique 12.

Le troisième filtre FIR C 35 reçoit en entrée la composante Q du signal de sortie du module de pré-distorsion numérique 12.

Le second filtre FIR B 34 reçoit en entrée la somme des composantes I et Q du signal de sortie du module de pré-distorsion numérique 12 par l'intermédiaire de l'additionneur 36.

Les sorties du premier filtre FIR A 33 et du second filtre FIR B 34 sont reliées au soustracteur 37 de manière à créer la composante I du signal de sortie $I_{OUT}$ du filtre numérique à coefficients complexes 13.

Les sorties du second filtre FIR B 34 et du troisième filtre FIR C 35 sont reliées à l'additionneur 38 de manière à créer la composante Q du signal de sortie $Q_{OUT}$ du filtre numérique à coefficients complexes 13.

Il est à noter que d'autres structures alternatives utilisant au moins trois filtres FIR pourraient également être utilisées pour réaliser le filtre numérique à coefficients complexes 13, sans s'écarter du cadre de la présente invention.

Les Figures 11 à 14 représentent des résultats de mesure à titre d'exemple d'une mise en œuvre du système de linéarisation 2 selon la présente invention.

L'amplificateur de puissance RF de classe G 3 peut présenter des variations importantes du gain en puissance et du déphasage de l'amplificateur 3 entre les différentes tensions d'alimentation discrètes fournies par le convertisseur continu-continu 4. Ces variations de gain et de phase conduisent alors à des distorsions importantes du signal à émettre.

La réponse de l'amplificateur de puissance RF de classe G 3 présente des caractéristiques de gain et de phase différentes entre chacune des tensions d'alimentation discrètes.

Le module de pré-distorsion numérique 12 a pour rôle de corriger le gain et la phase propres à chaque tension d'alimentation discrète vis-à-vis de valeurs cibles de gain et de phase identiques pour toutes les tensions d'alimentation discrètes.

Si l'on se réfère à la Figure 11, on peut voir qu'il y est représenté un graphique à titre d'exemple représentant le module du gain de la pré-distorsion Gain DPD (en dB), à générer pour linéariser l'amplificateur de puissance RF de classe G 3, en fonction de la puissance d'entrée Pin (en dBm).

La Figure 11 illustre, dans le cas du module de pré-distorsion numérique à une dimension 12, le processus réalisé par le module d'extraction de coefficients de pré-distorsion 15.

Pour chacune des quatre tensions d'alimentation discrètes pouvant être fournies par le convertisseur continu-continu 4, le nuage de points noirs représente les données mesurées en entrée de l'unité de séparation de données 21 du module d'extraction de coefficients de pré-distorsion 15, et la courbe de points blancs représente la réponse du module de pré-distorsion numérique 12 utilisant les coefficients de pré-distorsion qui ont été extraits séparément pour chaque tension d'alimentation discrète.

La réponse de l'amplificateur de puissance RF de classe G 3 couplé au module de pré-distorsion numérique à une dimension 12 est ensuite mesurée afin de procéder à l'extraction des coefficients du filtre numérique à coefficients complexes 13 par le module d'extraction de coefficients de filtre 16.

Le signal modulé à émettre possède, dans le cas de l'exemple représenté aux Figures 11 à 14, une bande passante de 1,3 MHz, la bande passante de génération et d'acquisition s'étendant sur une plage de fréquences de 40 MHz.

La réponse fréquentielle du filtre numérique à coefficients complexes 13 à extraire est ensuite déterminée par l'unité de calcul de réponse fréquentielle 27 au sein du module d'extraction de coefficients de filtre 16.

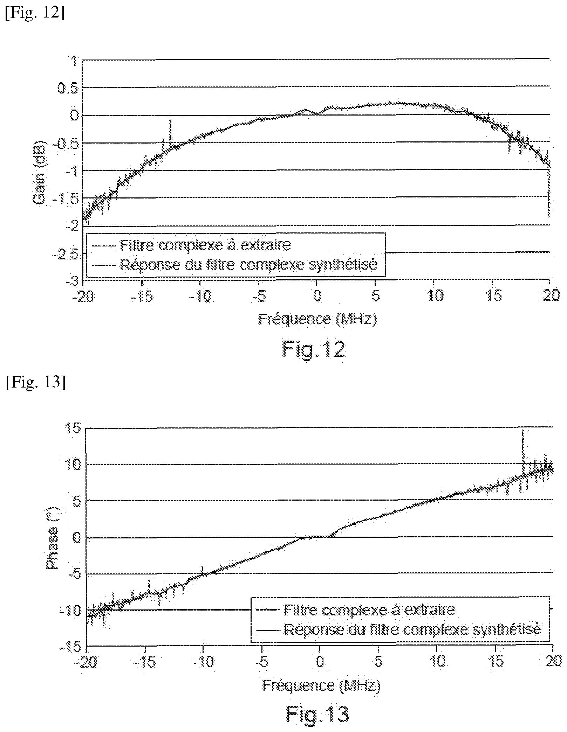

Si l'on se réfère aux Figures 12 et 13, on peut voir qu'il y est représenté des graphiques à titre d'exemple représentant respectivement le module du gain (en dB) du filtre numérique à coefficients complexes 13 à synthétiser et la phase (en degré) du gain du filtre numérique à coefficients complexes 13 à synthétiser, en fonction de la fréquence (en MHz).

Dans les Figures 12 et 13, les courbes en trait pointillé représentent les données issues de l'unité de calcul de réponse fréquentielle 27.

Les Figures 12 et 13 illustrent la fonction de transfert en module et en phase du filtre à coefficients complexes 13 à synthétiser pour linéariser l'amplificateur de puissance RF de classe G 3.

Les coefficients du filtre 13 sont extraits par l'unité d'extraction de coefficients de filtre 28 et implantés dans le filtre numérique à coefficients complexes 13.

Les courbes en trait plein sur les Figures 12 et 13 représentent la réponse fréquentielle du filtre numérique à coefficients complexes 13 synthétisée en utilisant, dans le cadre de cet exemple, soixante-quatre coefficients complexes.

La mise en œuvre du procédé de linéarisation permet d'extraire les paramètres du module de pré-distorsion numérique 12 et du filtre numérique à coefficients complexes 13. Le système de linéarisation en bande de base 2 selon l'invention pour un amplificateur de puissance RF 3 fonctionnant en classe G permet ainsi de supprimer les distorsions induites par ce mode de fonctionnement de l'amplificateur 3.

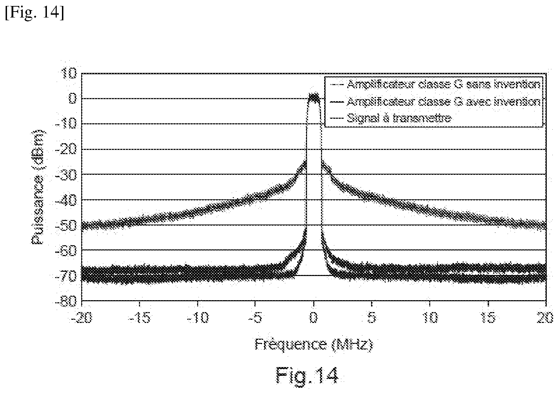

Si l'on se réfère à la Figure 14, on peut voir qu'il y est représenté un graphique à titre d'exemple représentant les spectres de sortie (Puissance en dBm) de l'amplificateur de puissance RF de classe G 3 avec et sans le système de linéarisation 2 de la présente invention, en fonction de la fréquence (en MHz).

La courbe en trait plein gras représente le spectre mesuré du signal à émettre.

La courbe en trait pointillé représente le spectre en sortie de l'amplificateur de puissance RF de classe G 3 seul, c'est-à-dire sans le système de linéarisation 2 de l'invention.

La courbe en trait plein non gras représente le spectre en sortie de l'amplificateur de puissance RF de classe G 3 couplé au système de linéarisation 2 selon l'invention.

On peut donc voir que le système de linéarisation 2 de l'invention a permis de linéariser l'amplificateur de puissance RF de classe G 3 en supprimant les distorsions induites par le mode de fonctionnement en classe G de l'amplificateur 3.


**Revendications**

1.  - Système de linéarisation en bande de base (2 ; 2') pour un amplificateur de puissance radiofréquence, RF, de classe G (3), ledit système de linéarisation (2 ; 2') comprenant :

    - une première entrée (2a) apte à recevoir un signal numérique en bande de base d'entrée à émettre comprenant une composante en phase, I, et une composante en quadrature, Q ;
    - une première sortie (2b) apte à délivrer un signal numérique en bande de base de sortie linéarisé à destination de l'amplificateur de puissance RF de classe G (3) ;
    - une seconde entrée (2c) apte à recevoir un signal numérique en bande de base provenant de la sortie (3a) de l'amplificateur de puissance RF de classe G (3) ; et
    - une seconde sortie (2d) apte à délivrer un signal numérique de sélection de tension d'alimentation à destination d'un convertisseur continu-continu (4) relié à l'amplificateur de puissance RF de classe G (3) ;

    ledit système de linéarisation (2 ; 2') comprenant en outre :

    - un module de sélection de tension d'alimentation d'amplificateur (11) dont l'entrée est reliée à la première entrée (2a) du système de linéarisation (2 ; 2') et dont la sortie est reliée à la seconde sortie (2d) du système de linéarisation (2 ; 2'), ledit module de sélection de tension d'alimentation d'amplificateur (11) étant configuré pour sélectionner une tension d'alimentation parmi au moins deux tensions d'alimentation continues du convertisseur continu-continu en fonction de l'amplitude du signal d'entrée à émettre reçu ;
    - un module de pré-distorsion numérique (12 ; 12') relié à la première entrée (2a) du système de linéarisation (2 ; 2') et configuré pour réaliser une pré-distorsion numérique des composantes I et Q du signal d'entrée à émettre reçu ; et
    - un module d'extraction de coefficients de pré-distorsion (15) ; ledit système de linéarisation (2 ; 2') comprenant en outre :
    - un filtre numérique à coefficients complexes (13) dont l'entrée est reliée à la sortie du module de pré-distorsion numérique (12 ; 12') et dont la sortie est reliée à la première sortie (2b) du système de linéarisation (2 ; 2') ; et
    - un module d'extraction de coefficients de filtre (16) dont une entrée est reliée à la seconde entrée (2c) du système de linéarisation (2 ; 2') et configuré pour extraire des coefficients de filtre (16a) utilisés par le filtre numérique à coefficients complexes (13) ;

le module d'extraction de coefficients de pré-distorsion (15) comprenant une première entrée (15a) reliée à l'une parmi la sortie du filtre numérique à coefficients complexes (13) et la sortie du module de pré-distorsion numérique (12 ; 12'), une deuxième entrée (15c) reliée à la seconde entrée (2c) du système de linéarisation (2 ; 2') et une troisième entrée (15d) reliée à la sortie du module de sélection de tension d'alimentation d'amplificateur (11), et étant configuré pour extraire des coefficients de pré-distorsion (15a) utilisés par le module de pré-distorsion numérique (12 ; 12') en fonction du signal numérique en bande de base provenant de la sortie (3a) de l'amplificateur de puissance RF de classe G (3), de l'une parmi la sortie du filtre numérique à coefficients complexes (13) et la sortie du module de pré-distorsion numérique (12 ; 12'), et de la tension d'alimentation sélectionnée par le module de sélection de tension d'alimentation d'amplificateur (11) ;

le module d'extraction de coefficients de filtre (16) étant configuré pour extraire les coefficients de filtre (16a) en fonction des composantes I et Q du signal à émettre, du signal numérique en bande de base provenant de la sortie (3a) de l'amplificateur de puissance RF de classe G (3), de la sortie du filtre numérique à coefficients complexes (13), et de la sortie du module de pré-distorsion numérique (12 ; 12') ;

le module d'extraction de coefficients de filtre (16) comprenant trois unités de retard temporel (23a, 23b, 23c), une unité de calcul de gain (24), une unité de calcul de signal attendu de sortie de filtre (25), deux unités de transformée de Fourrier rapide, FFT, (26a, 26b), une unité de calcul de réponse fréquentielle de filtre (27) et une unité d'extraction de coefficients de filtre (28),

les trois unités de retard temporel (23a, 23b, 23c) étant respectivement configurées pour compenser les temps de propagation et de traitement des composantes I et Q du signal à émettre, de la sortie du filtre numérique à coefficients complexes (13) et de la sortie du module de pré-distorsion numérique (12 ; 12'),

l'unité de calcul de gain (24) étant configurée pour calculer le gain complexe de l'amplificateur de puissance (3) à partir de la sortie retardée du filtre numérique à coefficients complexes (13) et du signal numérique en bande de base provenant de la sortie (3a) de l'amplificateur de puissance (3),

l'unité de calcul de signal attendu de sortie de filtre (25) étant configurée pour calculer le signal à générer par le filtre numérique (13) à partir du gain complexe calculé et des composantes I et Q retardées du signal à émettre, les deux unités FFT (26a, 26b) étant respectivement configurées pour calculer les transformées de Fourrier de la sortie retardée du module de pré-distorsion numérique (12 ; 12') et du signal à générer par le filtre numérique (13) calculé par l'unité de calcul de signal attendu de sortie de filtre (25),

l'unité de calcul de réponse fréquentielle de filtre (27) étant configurée pour calculer la réponse fréquentielle du filtre numérique (13) à générer à partir des deux transformées de Fourrier calculées par les unités FFT (26a, 26b), et

l'unité d'extraction de coefficients de filtre (28) étant configurée pour extraire les coefficients complexes (16a) du filtre numérique (13) à synthétiser en fonction de la réponse fréquentielle calculée par l'unité de calcul de réponse fréquentielle de filtre (27).

2. - Système de linéarisation (2) selon la revendication 1, **caractérisé par le fait que** le module de pré-distorsion numérique (12) est configuré pour réaliser une pré-distorsion numérique à une dimension en fonction de l'amplitude des composantes I et Q du signal à émettre.

3. - Système de linéarisation (2') selon la revendication 1, **caractérisé par le fait que** le module de pré-distorsion numérique (12') est configuré pour réaliser une pré-distorsion numérique à deux dimensions en fonction de l'amplitude des composantes I et Q du signal à émettre et de la tension d'alimentation sélectionnée par le module de sélection de tension d'alimentation d'amplificateur (11).

4. - Système de linéarisation (2 ; 2') selon l'une des revendications 1 à 3, **caractérisé par le fait que** le module de pré-distorsion numérique (12 ; 12') est configuré pour réaliser une pré-distorsion numérique de type polynomiale sans mémoire à l'aide d'au moins une table de correspondance stockée dans une mémoire (18 ; 18') ou d'une équation non-linéaire, ou pour réaliser une pré-distorsion numérique de type polynomiale à mémoire ou série de Volterra.

5. - Système de linéarisation (2 ; 2') selon l'une des revendications 1 à 4, **caractérisé par le fait que** le système de linéarisation (2 ; 2') comprend en outre un module d'alignement (14) disposé au niveau de la seconde entrée (2c) du système de linéarisation (2 ; 2'), ledit module d'alignement (14) étant configuré pour aligner en amplitude et en phase le signal numérique en bande de base provenant de la sortie (3a) de l'amplificateur de puissance RF de classe G (3) avec les autres signaux numériques en bande de base.

**6.** - Système de linéarisation (2 ; 2') selon l'une des revendications 1 à 5, **caractérisé par le fait que** le module d'extraction de coefficients de pré-distorsion (15) comprend des première et seconde unités de retard temporel (20a, 20b), une unité de séparation de données (21) et une unité d'extraction de coefficients de pré-distorsion (22), la première unité de retard temporel (20a) étant configurée pour compenser le temps de propagation et de traitement du signal issu de l'un parmi le filtre numérique à coefficients complexes (13) et le module de pré-distorsion numérique (12 ; 12'),

la seconde unité de retard temporel (20b) étant configurée pour compenser le temps de propagation et de traitement du signal issu de la sortie du module de sélection de tension d'alimentation d'amplificateur (11), l'unité de séparation de données (21) étant configurée pour séparer et stocker dans une mémoire les données concernant le signal numérique en bande de base provenant de la sortie (3a) de l'amplificateur de puissance (3) et le signal retardé issu de l'un parmi le filtre numérique à coefficients complexes (13) et le module de pré-distorsion numérique (12 ; 12') en fonction du signal retardé de sélection de tension d'alimentation, et l'unité d'extraction de coefficients de pré-distorsion (22) étant configurée pour extraire, pour chaque tension d'alimentation, les coefficients de pré-distorsion (15a) associés à partir des données stockées en mémoire par l'unité de séparation de données (21).

**7.** - Système de linéarisation (2 ; 2') selon l'une des revendications 1 à 6, **caractérisé par le fait que** le filtre numérique à coefficients complexes (13) est réalisé à l'aide de plusieurs filtres à réponse impulsionnelle finie, FIR, (29a, 29b, 30a, 30b ; 33, 34, 35).

**8.** - Système de linéarisation (2 ; 2') selon la revendication 7, **caractérisé par le fait que** le filtre numérique à coefficients complexes (13) comprend deux premiers filtres FIR (29a, 29b) identiques dont les coefficients correspondent à la partie réelle des coefficients complexes du filtre numérique à coefficients complexes (13), deux seconds filtres FIR (30a, 30b) identiques dont les coefficients correspondent à la partie imaginaire des coefficients complexes du filtre numérique à coefficients complexes (13), un additionneur (32) et un soustracteur (31),

l'un des premiers filtres FIR (29a), recevant en entrée la composante I du signal de sortie du module de pré-distorsion numérique (12 ; 12'), et l'un des seconds filtres FIR (30a), recevant en entrée la composante Q du signal de sortie du module de pré-distorsion numérique (12 ; 12'), étant reliés en sortie au soustracteur (31) de manière à créer la composante I du signal de sortie du filtre numérique à coefficients complexes (13), l'autre des premiers filtres FIR (29b), recevant en entrée la composante Q du signal de sortie du module de pré-distorsion numérique (12 ; 12'), et l'autre des seconds filtres FIR (30b), recevant en entrée la composante I du signal de sortie du module de pré-distorsion numérique (12 ; 12'), étant reliés en sortie à l'additionneur (32) de manière à créer la composante Q du signal de sortie du filtre numérique à coefficients complexes (13).

**9.** - Système de linéarisation (2 ; 2') selon la revendication 7, **caractérisé par le fait que** le filtre numérique à coefficients complexes (13) comprend un premier filtre FIR (33) dont les coefficients correspondent à la somme des parties réelle et imaginaire des coefficients du filtre numérique à coefficients complexes (13), un second filtre FIR (34) dont les coefficients correspondent à la partie imaginaire des coefficients du filtre numérique à coefficients complexes (13), un troisième filtre FIR (35) dont les coefficients correspondent à la différence entre la partie réelle et la partie imaginaire des coefficients du filtre numérique à coefficients complexes (13), deux additionneurs (36, 38) et un soustracteur (37),

le premier filtre FIR (33) recevant en entrée la composante I du signal de sortie du module de pré-distorsion numérique (12 ; 12'), le troisième filtre FIR (35) recevant en entrée la composante Q du signal de sortie du module de pré-distorsion numérique (12 ; 12'), le second filtre FIR (34) recevant en entrée la somme des composantes I et Q du signal de sortie du module de pré-distorsion numérique (12 ; 12') par l'intermédiaire de l'un des additionneurs (36), les sorties des premier et second filtres FIR (33, 34) étant reliées au soustracteur (37) de manière à créer la composante I du signal de sortie du filtre numérique à coefficients complexes (13), et les sorties des second et troisième filtres FIR (34, 35) étant reliées à l'autre des additionneurs (38) de manière à créer la composante Q du signal de sortie du filtre numérique à coefficients complexes (13).

**10.** - Système pour la technique de suivi d'enveloppe (1 ; 1') comprenant un système de linéarisation en bande de base (2 ; 2') selon l'une des revendications 1 à 9, un amplificateur de puissance RF de classe G (3), un convertisseur continu-continu (4), un convertisseur analogique-numérique (9), un convertisseur numérique-analogique (6), un mélangeur élévateur de fréquence (7) et un mélangeur abaisseur de fréquence (8),

le convertisseur continu-continu (4) étant disposé entre la seconde sortie (2d) du système de linéarisation (2 ; 2') et l'entrée d'alimentation (3b) de l'amplificateur de puissance (3),
le convertisseur numérique-analogique (6) et le mélangeur élévateur de fréquence (7) étant disposés en série entre la première sortie (2b) du système de linéarisation (2 ; 2') et l'entrée RF (3c) de l'amplificateur de puissance (3),
le mélangeur abaisseur de fréquence (8) et le convertisseur analogique-numérique (9) étant disposés en série entre la sortie (3a) de l'amplificateur de puissance (3) et la seconde entrée (2c) du système de linéarisation (2 ; 2').

11. - Procédé d'extraction des coefficients du filtre numérique à coefficients complexes (13) d'un système de linéarisation (2 ; 2') selon l'une des revendications 1 à 9, ledit procédé comprenant les étapes suivantes :

- l'acquisition des signaux d'entrée du module d'extraction de coefficients de filtre (16), à savoir les composantes I et Q du signal à émettre, le signal numérique en bande de base provenant de la sortie (3a) de l'amplificateur de puissance RF de classe G (3), la sortie du filtre numérique à coefficients complexes (13) et la sortie du module de pré-distorsion numérique (12 ; 12'), pendant une période de temps prédéfinie échantillonnée ;
- la compensation, par les trois unités de retard temporel (23a, 23b, 23c), des temps de propagation et de traitement des composantes I et Q du signal à émettre, de la sortie du filtre numérique à coefficients complexes (13) et de la sortie du module de pré-distorsion numérique (12 ; 12'), respectivement ;
- le calcul, à chaque instant d'échantillonnage, du gain complexe de l'amplificateur de puissance (3) à l'aide de l'unité de calcul de gain (24) à partir de la sortie retardée du filtre numérique à coefficients complexes (13) et du signal numérique en bande de base provenant de la sortie (3a) de l'amplificateur de puissance (3) ;
- le calcul, à chaque instant d'échantillonnage, du signal à générer par le filtre numérique (13) à l'aide de l'unité de calcul de signal attendu de sortie de filtre (25) à partir du gain complexe calculé et des composantes I et Q retardées du signal à émettre ;
- le calcul, sur un nombre d'échantillons prédéfini, des transformées de Fourrier de la sortie retardée du module de pré-distorsion numérique (12 ; 12') et du signal à générer par le filtre numérique (13) calculé par l'unité de calcul de signal attendu de sortie de filtre (25) ;
- le calcul de la fonction de transfert du filtre numérique (13) à synthétiser à l'aide de l'unité de calcul de réponse fréquentielle de filtre (27) à partir des deux transformées de Fourrier calculées ;
- le calcul des coefficients du filtre numérique (13) à l'aide de l'unité d'extraction de coefficients de filtre (28) à partir de la fonction de transfert calculée par l'unité de calcul de réponse fréquentielle de filtre (27) ; et
- la mise à jour des coefficients dans le filtre numérique à coefficients complexes (13) ;

le calcul et la mise à jour des coefficients de filtre étant réalisés de manière itérative à intervalles de temps prédéterminés, les coefficients de filtre étant affinés au fil des itérations successives.

**Patentansprüche**

1. System zur Basisband-Linearisierung (2; 2') für einen Hochfrequenz-Leistungsverstärker RF der Klasse G (3), wobei das Linearisierungssystem (2; 2') umfasst:

- einen ersten Eingang (2a), der imstande ist, ein zu sendendes digitales Basisband-Eingangssignal zu empfangen, das eine Inphase-Komponente I und eine Quadratur-Komponente Q umfasst;
- einen ersten Ausgang (2b), der imstande ist, dem Leistungsverstärker RF der Klasse G (3) ein linearisiertes digitales Basisband-Ausgangssignal bereitzustellen;
- einen zweiten Eingang (2c), der imstande ist, ein vom Ausgang (3a) des Leistungsverstärkers RF der Klasse G (3) kommendes digitales Basisband-Signal zu empfangen; und
- einen zweiten Ausgang (2d), der imstande ist, einem mit dem Leistungsverstärker RF der Klasse G (3) verbundenen Gleichstrom-Gleichstrom-Wandler (4) ein digitales Versorgungsspannungs-Auswahlsignal bereitzustellen;
wobei das Linearisierungssystem (2; 2') ferner umfasst:
- ein Verstärker-Versorgungsspannungs-Auswahlmodul (11), dessen Eingang mit dem ersten Eingang (2a) des Linearisierungssystems (2; 2') verbunden ist und dessen Ausgang mit dem zweiten Ausgang (2d) des Linearisierungssystems (2; 2') verbunden ist, wobei das Verstärker-Versorgungsspannungs-Auswahlmodul (11) ausgelegt ist, um eine Versorgungsspannung aus mindestens zwei Gleichstrom-Versorgungsspannungen des Gleichstrom-Gleichstrom-Wandlers in Abhängigkeit von der Amplitude des empfangenen zu sendenden Eingangssignals auszuwählen;

- ein digitales Vorverzerrungsmodul (12; 12'), das mit dem ersten Eingang (2a) des Linearisierungssystems (2; 2') verbunden ist und ausgelegt, um eine digitale Vorverzerrung der Komponenten I und Q des empfangenen zu sendenden Eingangssignals durchzuführen; und

- ein Vorverzerrungskoeffizient-Extraktionsmodul (15);

wobei das Linearisierungssystem (2; 2') ferner umfasst:

- einen digitalen Filter mit komplexen Koeffizienten (13), dessen Eingang mit dem Ausgang des digitalen Vorverzerrungsmoduls (12; 12') verbunden ist und dessen Ausgang mit dem ersten Ausgang (2b) des Linearisierungssystems (2; 2') verbunden ist; und

- ein Filterkoeffizient-Extraktionsmodul (16), von dem ein Eingang mit dem zweiten Eingang (2c) des Linearisierungssystems (2; 2') verbunden ist und ausgelegt, um von dem digitalen Filter mit komplexen Koeffizienten (13) verwendete Filterkoeffizienten (16a) zu extrahieren;

wobei das Vorverzerrungskoeffizient-Extraktionsmodul (15) einen ersten Eingang (15a) umfasst, der entweder mit dem Ausgang des digitalen Filters mit komplexen Koeffizienten (13) oder mit dem Ausgang des digitalen Vorverzerrungsmoduls (12; 12') verbunden ist, einen zweiten Eingang (15c), der mit dem zweiten Eingang (2c) des Linearisierungssystems (2; 2') verbunden ist und einen dritten Eingang (15d), der mit dem Ausgang des Verstärker-Versorgungsspannungs-Auswahlmoduls (11) verbunden ist und ausgelegt, um von dem digitalen Vorverzerrungsmodul (12; 12') in Abhängigkeit vom digitalen Basisbandsignal verwendete Vorverzerrungs-Koeffizienten (15a) zu extrahieren, wobei das digitall Basisbandsignal vom Ausgang (3a) des Leistungsverstärkers RF der Klasse G (3), entweder vom Ausgang des digitalen Filters mit komplexen Koeffizienten (13) oder vom Ausgang des digitalen Vorverzerrungsmoduls (12; 12') und von der vom Verstärker-Versorgungsspannungs-Auswahlmodul (11) ausgewählten Versorgungsspannung kommt;

wobei das Filterkoeffizient-Extraktionsmodul (16) ausgelegt ist, um die Filterkoeffizienten (16a) in Abhängigkeit von den Komponenten I und Q des zu sendenden Signals, des digitalen Basisbandsignals, das vom Ausgang (3a) des Leistungsverstärkers RF der Klasse G (3), vom Ausgang des digitalen Filters mit komplexen Koeffizienten (13) und vom Ausgang des digitalen Vorverzerrungsmodul (12; 12') kommt, zu extrahieren;

wobei das Filterkoeffizient-Extraktionsmodul (16) drei Zeitverzögerungseinheiten (23a, 23b, 23c), eine Verstärkungsberechnungseinheit (24), eine Einheit zur Berechnung des erwarteten Filterausgangssignals (25), zwei schnelle Fourier-Transformationseinheiten FFT (26a, 26b), eine Einheit zur Berechnung des Filterfrequenzgangs (27) und eine Filterkoeffizient-Extraktionseinheit (28) umfasst, wobei die drei Zeitverzögerungseinheiten (23a, 23b, 23c) jeweils ausgelegt sind, um die Zeiten zur Weiterverbreitung und Verarbeitung der Komponenten I und Q des zu sendenden Signals vom Ausgang des digitalen Filters mit komplexen Koeffizienten (13) und vom Ausgang des digitalen Vorverzerrungsmoduls (12; 12') zu kompensieren,

wobei die Verstärkungsberechnungseinheit (24) ausgelegt ist, um die komplexe Verstärkung des Leistungsverstärkers (3) ausgehend von dem verzögerten Ausgang des digitalen Filters mit komplexen Koeffizienten (13) und dem digitalen Basisbandsignal, das vom Ausgang (3a) des Leistungsverstärkers (3) kommt, zu berechnen,

wobei die Einheit zur Berechnung des erwarteten Filterausgangssignals (25) ausgelegt ist, um das von dem digitalen Filter (13) zu generierende Signal ausgehend von der berechneten komplexen Verstärkung und den verzögerten Komponenten I und Q des zu sendenden Signals zu berechnen,

wobei die zwei FFT-Einheiten (26a, 26b) jeweils ausgelegt sind, um die Fourier-Transformationen des verzögerten Ausgangs des digitalen Vorverzerrungsmoduls (12; 12') und des von dem digitalen Filter (13) zu generierenden, von der Einheit zur Berechnung des erwarteten Filterausgangssignals (25) berechnete Signal zu berechnen,

wobei die Einheit zur Berechnung des Filterfrequenzgangs (27) ausgelegt ist, um den Frequenzgang des digitalen Filters (13) zu berechnen, der ausgehend von den zwei von den FFT-Einheiten (26a, 26b) berechneten Fourier-Transformationen zu generieren ist, und

wobei die Filterkoeffizient-Extraktionseinheit (28) ausgelegt ist, um die komplexen Koeffizienten (16a) des digitalen Filters (13) zu extrahieren, die in Abhängigkeit von dem von der Einheit zur Berechnung des Filterfrequenzgangs (27) berechneten Frequenzgang zu synthetisieren sind.

2. Linearisierungssystem (2) nach Anspruch 1, **dadurch gekennzeichnet, dass** das digitale Vorverzerrungsmodul (12) ausgelegt ist, um eine digitale Vorverzerrung in einer Dimension in Abhängigkeit von der Amplitude der Komponenten I und Q des zu sendenden Signals durchzuführen.

3. Linearisierungssystem (2') nach Anspruch 1, **dadurch gekennzeichnet, dass** das digitale Vorverzerrungsmodul (12') ausgelegt ist, um eine digitale Vorverzerrung in zwei Dimensionen in Abhängigkeit von der Amplitude der Komponenten I und Q des zu sendenden Signals und von der vom Verstärker-Versorgungsspannungs-Auswahlmodul (11) ausgewählten Versorgungsspannung durchzuführen.

4. Linearisierungssystem (2; 2') nach einem der Ansprüche 1 bis 3, **dadurch gekennzeichnet, dass** das digitale Vorverzerrungsmodul (12; 12') ausgelegt ist, um eine digitale Vorverzerrung polynominalen Typs ohne Speicher mit Hilfe von mindestens einer Entsprechungstabelle, die in einem Speicher (18; 18') gespeichert ist, oder einer nicht-linearen Gleichung durchzuführen, oder um eine digitale Vorverzerrung polynominalen Typs mit Speicher oder Volterra-Reihe durchzuführen.

5. Linearisierungssystem (2; 2') nach einem der Ansprüche 1 bis 4, **dadurch gekennzeichnet, dass** das Linearisierungssystem (2; 2') ferner ein Ausrichtungsmodul (14) umfasst, das im Bereich des zweiten Eingangs (2c) des Linearisierungssystems (2; 2') angeordnet ist, wobei das Ausrichtungsmodul (14) ausgelegt ist, um das vom Ausgang (3a) des Leistungsverstärkers RF der Klasse G (3) kommende digitale Basisbandsignal mit den anderen digitalen Basisbandsignalen amplituden- und phasenmäßig auszurichten.

6. Linearisierungssystem (2; 2') nach einem der Ansprüche 1 bis 5, **dadurch gekennzeichnet, dass** das Vorverzerrungskoeffizient-Extraktionsmodul (15) eine erste und zweite Zeitverzögerungseinheit (20a, 20b), eine Datentrennungseinheit (21) und eine Vorverzerrungs-Koeffizienten-Extraktionseinheit (22) umfasst,

   wobei die erste Zeitverzögerungseinheit (20a) ausgelegt ist, um die Zeit zur Weiterverbreitung und Verarbeitung des Signals, das entweder aus dem digitalen Filter mit komplexen Koeffizienten (13) oder dem digitalen Vorverzerrungsmodul (12; 12') hervorgegangen ist, zu kompensieren,
   wobei die zweite Zeitverzögerungseinheit (20b) ausgelegt ist, um die Zeit zur Weiterverbreitung und Verarbeitung des Signals, das aus dem Ausgang des Verstärker-Versorgungsspannungs-Auswahlmoduls (11) hervorgegangen ist, zu kompensieren,
   wobei die Datentrennungseinheit (21) ausgelegt ist, um die Daten, die das digitale Basisbandsignal betreffen, das vom Ausgang (3a) des Leistungsverstärkers (3) kommt, und das verzögerte Signal, das entweder aus dem digitalen Filter mit komplexen Koeffizienten (13) oder dem digitalen Vorverzerrungsmodul (12; 12') in Abhängigkeit vom verzögerten Versorgungsspannungs-Auswahlsignal hervorgegangen ist, zu trennen und in einem Speicher zu speichern, und
   die Vorverzerrungs-Koeffizienten-Extraktionseinheit (22) ausgelegt ist, um für jede Versorgungsspannung die entsprechenden Vorverzerrungs-Koeffizienten (15a) ausgehend von den von der Datentrennungseinheit (21) im Speicher gespeicherten Daten zu extrahieren.

7. Linearisierungssystem (2; 2') nach einem der Ansprüche 1 bis 6, **dadurch gekennzeichnet, dass** der digitale Filter mit komplexen Koeffizienten (13) mit Hilfe von mehreren Filtern mit endlicher Impulsantwort FIR, (29a, 29b, 30a, 30b; 33, 34, 35) hergestellt wird.

8. Linearisierungssystem (2; 2') nach Anspruch 7, **dadurch gekennzeichnet, dass** der digitale Filter mit komplexen Koeffizienten (13) zwei identische erste FIR-Filter (29a, 29b), deren Koeffizienten dem realen Teil der komplexen Koeffizienten des digitalen Filters mit komplexen Koeffizienten (13) entsprechen, zwei identische zweite FIR-Filter (30a, 30b), deren Koeffizienten dem imaginären Teil der komplexen Koeffizienten des digitalen Filters mit komplexen Koeffizienten (13) entsprechen, einen Addierer (32) und einen Subtrahierer (31) umfasst,

   wobei einer der ersten FIR-Filter (29a), der am Eingang die Komponente I des Ausgangssignals des digitalen Vorverzerrungsmoduls (12; 12') empfängt, und einer der zweiten FIR-Filter (30a), der am Eingang die Komponente Q des Ausgangssignals des digitalen Vorverzerrungsmoduls (12; 12') empfängt, am Ausgang mit dem Subtrahierer (31) derart verbunden sind, dass die Komponente I des Ausgangssignals des digitalen Filters mit komplexen Koeffizienten (13) kreiert wird,
   wobei der andere der ersten FIR-Filter (29b), der am Eingang die Komponente Q des Ausgangssignals des digitalen Vorverzerrungsmoduls (12; 12') empfängt, und der andere der zweiten FIR-Filter (30b), der am Eingang die Komponente I des Ausgangssignals des digitalen Vorverzerrungsmoduls (12; 12') empfängt, am Ausgang mit dem Addierer (32) derart verbunden sind, dass die Komponente Q des Ausgangssignals des digitalen Filters mit komplexen Koeffizienten (13) kreiert wird.

9. Linearisierungssystem (2; 2') nach Anspruch 7, **dadurch gekennzeichnet, dass** der digitale Filter mit komplexen Koeffizienten (13) einen ersten FIR-Filter (33), dessen Koeffizienten der Summe des realen und imaginären Teils der Koeffizienten des digitalen Filters mit komplexen Koeffizienten (13) entsprechen, einen zweiten FIR-Filter (34), dessen Koeffizienten dem imaginären Teil der Koeffizienten des digitalen Filters mit komplexen Koeffizienten (13) entsprechen, einen dritten FIR-Filter (35), dessen Koeffizienten der Differenz zwischen dem realen Teil und dem imaginären Teil der Koeffizienten des digitalen Filters mit komplexen Koeffizienten (13) entsprechen, zwei Addierer (36, 38) und einen Subtrahierer (37) umfasst,

wobei der erste FIR-Filter (33) am Eingang die Komponente I des Ausgangssignals des digitalen Vorverzerrungsmoduls (12; 12') empfängt,
wobei der dritte FIR-Filter (35) am Eingang die Komponente Q des Ausgangssignals des digitalen Vorverzerrungsmoduls (12; 12') empfängt,
wobei der zweite FIR-Filter (34) am Eingang die Summe der Komponenten I und Q des Ausgangssignals des digitalen Vorverzerrungsmoduls (12; 12') über einen der Addierer (36) empfängt,
wobei die Ausgänge des ersten und zweiten FIR-Filters (33, 34) mit dem Subtrahierer (37) derart verbunden sind, dass die Komponente I des Ausgangssignals des digitalen Filters mit komplexen Koeffizienten (13) kreiert wird, und
wobei die Ausgänge des zweiten und dritten FIR-Filters (34, 35) mit dem anderen der Addierer (38) derart verbunden sind, dass die Komponente Q des Ausgangssignals des digitalen Filters mit komplexen Koeffizienten (13) kreiert wird.

10. System für die Hüllkurven-Nachführungstechnik (1; 1'), umfassend ein System zur Basisband-Linearisierung (2; 2') nach einem der Ansprüche 1 bis 9, einen RF-Leistungsverstärker der Klasse G (3), einen Gleichstrom-Gleichstrom-Wandler (4), einen Analog-Digital-Wandler (9), einen Digital-Analog-Wandler (6), einen Aufwärts-Frequenzmischer (7) und einen Abwärts-Frequenzmischer (8),

wobei der Gleichstrom-Gleichstrom-Wandler (4) zwischen dem zweiten Ausgang (2d) des Linearisierungssystems (2; 2') und dem Versorgungseingang (3b) des Leistungsverstärkers (3) angeordnet ist,
wobei der Digital-Analog-Wandler (6) und der Aufwärts-Frequenzmischer (7) in Reihe zwischen dem ersten Ausgang (2b) des Linearisierungssystems (2; 2') und dem RF-Eingang (3c) des Leistungsverstärkers (3) angeordnet sind,
wobei der Abwärts-Frequenzmischer (8) und der Analog-Digital-Wandler (9) in Reihe zwischen dem Ausgang (3a) des Leistungsverstärkers (3) und dem zweiten Eingang (2c) des Linearisierungssystems (2; 2') angeordnet sind.

11. Verfahren zur Extraktion der Koeffizienten des digitalen Filters mit komplexen Koeffizienten (13) eines Linearisierungssystems (2; 2') nach einem der Ansprüche 1 bis 9, wobei das Verfahren die folgenden Schritte umfasst:

- das Erfassen der Eingangssignale des Filterkoeffizient-Extraktionsmoduls (16), nämlich der Komponenten I und Q des zu sendenden Signals, des digitalen Basisband-Signals, das vom Ausgang (3a) des RF-Leistungsverstärkers der Klasse G (3), dem Ausgang des digitalen Filters mit komplexen Koeffizienten (13) und dem Ausgang des digitalen Vorverzerrungsmoduls (12; 12') kommt, in einem vorher festgelegten Samplingzeitraum;
- das Kompensieren, durch die drei Zeitverzögerungseinheiten (23a, 23b, 23c), der Zeiten zur Weiterverbreitung und Verarbeitung der Komponenten I und Q des zu sendenden Signals jeweils vom Ausgang des digitalen Filters mit komplexen Koeffizienten (13) und vom Ausgang des digitalen Vorverzerrungsmoduls (12; 12'),
- das Berechnen, zu jedem Samplingzeitpunkt, der komplexen Verstärkung des Leistungsverstärkers (3) mit Hilfe der Verstärkungsberechnungseinheit (24) ausgehend von dem verzögerten Ausgang des digitalen Filters mit komplexen Koeffizienten (13) und dem digitalen Basisbandsignal, das vom Ausgang (3a) des Leistungsverstärkers (3) kommt;
- das Berechnen, zu jedem Samplingzeitpunkt, des von dem digitalen Filter (13) zu generierenden Signals mit Hilfe der Einheit zur Berechnung des erwarteten Filterausgangssignals (25) ausgehend von der berechneten komplexen Verstärkung und der verzögerten Komponenten I und Q des zu sendenden Signals;
- das Berechnen, anhand einer vorher festgelegten Anzahl von Sampeln, der Fourier-Transformationen des verzögerten Ausgangs des digitalen Vorverzerrungsmoduls (12; 12') und des von dem digitalen Filter (13) zu generierenden, von der Einheit zur Berechnung des erwarteten Filterausgangssignals (25) berechneten Signals;
- das Berechnen der mit Hilfe der Einheit zur Berechnung des Filterfrequenzgangs (27) aus zwei berechneten Fourier-Transformationen zu synthetisierenden Transferfunktion des digitalen Filters (13);
- das Berechnen der Koeffizienten des digitalen Filters (13) mit Hilfe der Filterkoeffizient-Extraktionseinheit (28) ausgehend von der von der Einheit zur Berechnung des Frequenzgangs (27) berechneten Transferfunktion;
- das Aktualisieren der Koeffizienten im digitalen Filter mit komplexen Koeffizienten (13);

wobei die Berechnung und die Aktualisierung der Filterkoeffizienten wiederholt in vorher festgelegten Zeitintervallen durchgeführt werden, wobei die Filterkoeffizienten im Laufe der aufeinanderfolgenden Wiederholungen verfeinert werden.

**Claims**

1. - A system (2; 2') of baseband linearization for a class G radiofrequency (RF) power amplifier (3), said linearization system (2; 2') comprising:

- a first input (2a) able to receive an input digital baseband signal to be emitted comprising an in-phase component, I, and a quadrature component, Q;
- a first output (2b) able to output a linearized output baseband digital signal to the class G RF power amplifier (3) ;
- a second input (2c) able to receive a baseband digital signal coming from the output (3a) of the class G RF power amplifier (3); and
- a second output (2d) able to output a digital power supply voltage selection signal to a DC-DC converter (4) connected to the class G RF power amplifier (3);

said linearization system (2; 2') further comprising:

- a module (11) for selecting the amplifier power supply voltage, the input of which is connected to the first input (2a) of the linearization system (2; 2') and the output of which is connected to the second output (2d) of the linearization system (2; 2'), said module (11) for selecting the amplifier power supply voltage being configured to select a power supply voltage from among at least two DC power supply voltages of the DC-DC converter as a function of the amplitude of the received input signal to be emitted;
- a digital predistortion module (12; 12') connected to the first input (2a) of the linearization system (2; 2') and configured to perform a digital predistortion of the I and Q components of the received input signal to be emitted; and
- a module for extracting predistortion coefficients (15);
said linearization system (2; 2') further comprising:
- a digital filter with complex coefficients (13), the input of which is connected to the output of the digital predistortion module (12; 12') and the output of which is connected to the first output (2b) of the linearization system (2; 2'); and
- a module for extracting filter coefficients (16), an input of which is connected to the second input (2c) of the linearization system (2; 2') and configured to extract filter coefficients (16a) used by the digital filter with complex coefficients (13);
the module for extracting predistortion coefficients (15) comprising a first input (15a) connected to one among the output of the digital filter with complex coefficients (13) and the output of the digital predistortion module (12; 12'), a second input (15c) connected to the second input (2c) of the linearization system (2; 2') and a third input (15d) connected to the output of the module (11) for selecting the amplifier power supply voltage, and being configured to extract predistortion coefficients (15a) used by the digital predistortion module (12; 12') as a function of the baseband digital signal coming from the output (3a) of the class G RF power amplifier (3), from one among the output of the digital filter with complex coefficients (13) and the output of the digital predistortion module (12; 12'), and from the power supply voltage selected by the module (11) for selecting the amplifier power supply voltage;
the module for extracting filter coefficients (16) being configured to extract the filter coefficients (16a) as a function of the I and Q components of the signal to be emitted, of the baseband digital signal coming from the output (3a) of the class G RF power amplifier (3), of the output of the digital filter with complex coefficients (13), and of the output of the digital predistortion module (12; 12');
the module for extracting filter coefficients (16) comprising three time delay units (23a, 23b, 23c), a gain calculation unit (24), a filter output expected signal calculation unit (25), two fast Fourier transform, FFT, units (26a, 26b), a filter frequency response calculation unit (27) and a filter coefficient extraction unit (28),
the three time delay units (23a, 23b, 23c) respectively being configured to compensate the propagation and processing times of the I and Q components of the signal to be emitted, of the output of the digital filter with complex coefficients (13) and of the output of the digital predistortion module (12; 12'),
the gain calculation unit (24) being configured to calculate the complex gain of the power amplifier (3) from the delayed output of the digital filter with complex coefficients (13) and the baseband digital signal coming from the output (3a) of the power amplifier (3),

the filter output expected signal calculation unit (25) being configured to calculate the signal to be generated by the digital filter (13) from the calculated complex gain and the delayed I and Q components of the signal to be emitted,

the two FFT units (26a, 26b) respectively being configured to calculate the Fourier transforms of the delayed output of the digital predistortion module (12; 12') and the signal to be generated by the digital filter (13) calculated by the filter output expected signal calculation unit (25),

the filter frequency response calculation unit (27) being configured to calculate the frequency response of the digital filter (13) to be generated from the two Fourier transforms calculated by the FFT units (26a, 26b), and

the filter coefficient extraction unit (28) being configured to extract the complex coefficients (16a) of the digital filter (13) to be synthesized as a function of the frequency response calculated by the filter frequency response calculation unit (27).

2. - The linearization system (2) according to claim 1, **characterized in that** the digital predistortion module (12) is configured to carry out a one-dimensional digital predistortion as a function of the amplitude of the I and Q components of the signal to be emitted.

3. - The linearization system (2') according to claim 1, **characterized in that** the digital predistortion module (12') is configured to carry out a two-dimensional digital predistortion as a function of the amplitude of the I and Q components of the signal to be emitted and of the power supply voltage selected by the module for selecting the amplifier power supply voltage (11).

4. - The linearization system (2; 2') according to one of claims 1 to 3, **characterized in that** the digital predistortion module (12; 12') is configured to perform a digital predistortion of the polynomial without memory type using at least one look-up table stored in a memory (18; 18') or a nonlinear equation, or to perform a digital predistortion of the polynomial with memory type or of the Volterra series type.

5. - The linearization system (2; 2') according to one of claims 1 to 4, **characterized in that** the linearization system (2; 2') further comprises an alignment module (14) arranged at the second input (2c) of the linearization system (2; 2'), said alignment module (14) being configured to align, in amplitude and in phase, the baseband digital signal coming from the output (3a) of the class G RF power amplifier (3) with the other baseband digital signals.

6. - The linearization system (2; 2') according to one of claims 1 to 5, **characterized in that** the module for extracting predistortion coefficients (15) comprises first and second time delay units (20a, 20b), a data separation unit (21) and a unit for extracting predistortion coefficients (22),

the first time delay unit (20a) being configured to compensate the propagation and processing time of the signal coming from one among the digital filter with complex coefficients (13) and the digital predistortion module (12; 12'),

the second time delay unit (20b) being configured to compensate the propagation and processing time of the signal coming from the output of the module for selecting the amplifier power supply voltage (11),

the data separation unit (21) being configured to separate and store, in a memory, the data concerning the baseband digital signal coming from the output (3a) of the power amplifier (3) and the delayed signal coming from one among the digital filter with complex coefficients (13) and the digital predistortion module (12; 12') as a function of the delayed power supply voltage selection signal, and

the predistortion coefficient extraction unit (22) being configured to extract, for each power supply voltage, the associated predistortion coefficients (15a) from data stored in memory by the data separation unit (21).

7. - The linearization system (2; 2') according to one of claims 1 to 6, **characterized in that** the digital filter with complex coefficients (13) is made using several finite impulse response (FIR) filters (29a, 29b, 30a, 30b; 33, 34, 35).

8. - The linearization system (2; 2') according to claim 7, **characterized in that** the digital filter with complex coefficients (13) comprises two identical first FIR filters (29a, 29b), the coefficients of which correspond to the real part of the complex coefficients of the digital filter with complex coefficients (13), two identical second FIR filters (30a, 30b), the coefficients of which correspond to the imaginary part of the complex coefficients of the digital filter with complex coefficients (13), an adder (32) and a subtracter (31),

one of the first FIR filters (29a), receiving as input the I component of the output signal of the digital predistortion module (12; 12'), and one of the second FIR filters (30a), receiving as input the Q component of the output signal of the digital predistortion module (12; 12'), being connected at the output to the subtracter (31) so as to create the I component of the output signal of the digital filter with complex coefficients (13),

the other of the first FIR filters (29b), receiving as input the Q component of the output signal of the digital predistortion module (12; 12'), and the other of the second FIR filters (30b), receiving as input the I component of the output signal of the digital predistortion module (12; 12'), being connected at the output to the adder (32) so as to create the Q component of the output signal of the digital filter with complex coefficients (13).

9. - The linearization system (2; 2') according to claim 7, **characterized in that** the digital filter with complex coefficients (13) comprises a first FIR filter (33), the coefficients of which correspond to the sum of the real and imaginary parts of the coefficients of the digital filter with complex coefficients (13), a second FIR filter (34), the coefficients of which correspond to the imaginary part of the coefficients of the digital filter with complex coefficients (13), a third FIR filter (35), the coefficients of which correspond to the difference between the real part and the imaginary part of the coefficients of the digital filter with complex coefficients (13), two adders (36, 38) and a subtracter (37),

the first FIR filter (33) receiving, as input, the I component of the output signal of the digital predistortion module (12; 12'),
the third FIR filter (35) receiving, as input, the Q component of the output signal of the digital predistortion module (12; 12'),
the second FIR filter (34) receiving, as input, the sum of the I and Q components of the output signal of the digital predistortion module (12; 12') by means of one of the adders (36),
the outputs of the first and second FIR filters (33, 34) being connected to the subtracter (37) so as to create the I component of the output signal of the digital filter with complex coefficients (13), and
the outputs of the second and third FIR filters (34, 35) being connected to the other of the adders (38) so as to create the Q component of the output signal of the digital filter with complex coefficients (13).

10. - A system for the envelope tracking technique (1; 1') comprising a baseband linearization system (2; 2') according to one of claims 1 to 9, a class G RF power amplifier (3), a DC-DC converter (4), an analog-to-digital converter (9), a digital-to-analog converter (6), an up-conversion mixer (7) and a down-conversion mixer (8), the DC-DC converter (4) being arranged between the second output (2d) of the linearization system (2; 2') and the power supply input (3b) of the power amplifier (3),

the digital-to-analog converter (6) and the up-conversion mixer (7) being arranged in series between the first output (2b) of the linearization system (2; 2') and the RF input (3c) of the power amplifier (3),
the down-conversion mixer (8) and the analog-to-digital converter (9) being arranged in series between the output (3a) of the RF power amplifier (3) and the second input (2c) of the linearization system (2; 2').

11. - A method for extracting coefficients of the digital filter with complex coefficients (13) from a linearization system (2; 2') according to one of claims 1 to 9, said method comprising the following steps:

- acquiring input signals of the module for extracting filter coefficients (16), namely the I and Q components of the signal to be emitted, the baseband digital signal coming from the output (3a) of the class G RF power amplifier (3), the output of the digital filter with complex coefficients (13) and the output of the digital predistortion module (12;12'), during a sampled predefined time period;
- compensating, by the three time delay units (23a, 23b, 23c), propagation and processing times of the I and Q components of the signal to be emitted, of the output of the digital filter with complex coefficients (13) and of the output of the digital predistortion module (12;12'), respectively;
- calculating, at each sampling time, the complex gain of the power amplifier (3) using the gain calculation unit (24) from the delayed output of the digital filter with complex coefficients (13) and the baseband digital signal coming from the output (3a) of the power amplifier (3);
- calculating, at each sampling time, the signal to be generated by the digital filter (13) using the filter output expected signal calculation unit (25) from the complex gain calculated and the delayed I and Q components of the signal to be emitted;
- calculating, on a predefined number of samples, Fourier transforms of the delayed output of the digital predistortion module (12; 12') and of the signal to be generated by the digital filter (13) calculated by the filter output expected signal calculation unit (25);
- calculating the transfer function of the digital filter (13) to be synthesized using the filter frequency response calculation unit (27) from the two calculated Fourier transforms;
- calculating the coefficients of the digital filter (13) using the filter coefficient extraction unit (28) from the transfer function calculated by the filter frequency response calculation unit (27); and
- updating the coefficients in the digital filter with complex coefficients (13);

the calculation and updating of the filter coefficients being done iteratively at predetermined time intervals, the filter coefficients being refined over the course of the successive iterations.

[Fig. 1]

Fig.1

[Fig. 2]

Fig.2

[Fig. 3]

Fig.3

[Fig. 4]

Fig.4

[Fig. 5]

Fig.5

[Fig. 6]

Fig.6

[Fig. 7]

Fig.7

[Fig. 8]

Fig.8

[Fig. 9]

Fig.9

[Fig. 10]

Fig.10

[Fig. 11]

Fig.11

[Fig. 12]

Fig.12

[Fig. 13]

Fig.13

[Fig. 14]

Fig.14

**EP 3 785 367 B1**

## RÉFÉRENCES CITÉES DANS LA DESCRIPTION

**Documents brevets cités dans la description**

- US 2010277236 A1